(19) Europäisches Patentamt
European Patent Office
Office européen des brevets

(11) Publication number: **0 040 923**
**B1**

(12) **EUROPEAN PATENT SPECIFICATION**

(45) Date of publication of patent specification: **02.05.85**

(51) Int. Cl.$^4$: **G 03 C 1/68,** C 08 F 220/36, C 08 G 18/67, C 09 J 7/02

(21) Application number: **81302093.0**

(22) Date of filing: **11.05.81**

# (54) Compositions for providing abherent coatings; poly (fluorooxyalkylene) urethane acrylates.

(30) Priority: **20.05.80 US 151643**
**20.05.80 US 151644**

(43) Date of publication of application:
**02.12.81 Bulletin 81/48**

(45) Publication of the grant of the patent:
**02.05.85 Bulletin 85/18**

(84) Designated Contracting States:
**DE FR GB IT**

(56) References cited:
**FR-A-2 453 871**
**GB-A- 892 818**
**GB-A-1 564 542**
**GB-A-2 019 254**
**US-A-3 240 642**
**US-A-4 066 802**

**RESEARCH DISCLOSURE, vol. 177, no. 118, February 1974, pages 24 to 28, Industrial Opportunities Ltd., Havant, Hampshire (GB); "Repellent composition and elements containing the same"**

(73) Proprietor: **MINNESOTA MINING AND MANUFACTURING COMPANY**
**3M Center, P.O. Box 33427**
**St. Paul, MN 55133 (US)**

(72) Inventor: **Williams, Brian H.**
**3M Center**
**St. Paul Minnesota 55144 (US)**
Inventor: **Young, Chung I.**
**3M Center**
**St. Paul Minnesota 55144 (US)**

(74) Representative: **Baillie, Iain Cameron et al**
**c/o Ladas & Parry Isartorplatz 5**
**D-8000 München 2 (DE)**

**EP 0 040 923 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Technical Field

The present invention relates to unique radiation curable abherent coating compositions for providing solvent-resistant abhesive coatings and to substrates coated with same. More particularly, the invention relates to radiation crosslinked coatings and films having polyfluorinated acrylate groups incorporated therein to a high degree. The invention further relates to a method for providing such abherent coatings and films, and to particularly preferred novel poly(fluorooxyalkylene)urethane acrylate compounds useful in said coating compositions. The invention further relates to using the abherent coating composition in an image transfer system.

### Background Art

Adhesive coatings are used in applications where adhesion between the surfaces of two materials is to be controlled. Such applications include industrial operations such as die casting, injection and blow molding, melt spinning, vacuum forming, stamping and the like. Yet another application is in the area of transfer adhesives wherein a solvent based adhesive is applied to an abhesive coated release surface to which the adhesive weakly adheres. The adhesive surface of the composite structure is applied to another receiver surface and the abhesive release backing is peeled away to expose the adhesive material for a variety of desired applications. Still another application is in the area of image transfer, wherein an abhesive coated surface is printed with a design which, due to the release properties of the abhesive coating, can be transferred to another substrate, generally by heat and pressure. One such image transfer system is disclosed in U.S. Patent No. 3,240,642. However, with the system disclosed in U.S. Patent 3,240,642 the adhesive layer is disposed between the image and the receiving substrate. Thus, the image is an unprotected one which can blur, or break in its application to the receiver surface.

Abhesive materials known in the art of industrial operations include liquid or powdered solid materials such as silicones, fluorocarbon containing polymers; waxes, stearates, talc, mica, graphite and the like. GB—A—1,564,542 discloses a release coating comprising a prepolymer material, and a waxy material which may be a fluorocarbon.

### Disclosure of Invention

The radiation curable abhesive coating compositions of the present invention comprise:

(a) a fluorocarbon, which is a polyfluorinated acrylate compound present in an amount such that said composition is provided with at least 0.05 percent by weight fluorine;

(b) a polyethylenically unsaturated crosslinking agent which differs from the fluorocarbon; and

(c) a film-forming organic polymer.

The present invention is an advance over the prior art in that it provides novel radiation curable compositions for providing solvent-resistant abhesive coatings having characteristics which make them of particular use as abherent release coatings in the area of image transfer, in particular, wherein the image to be transferred is a fused xerographic one. The cured compositions of the present invention provide abherent surfaces which can carry an image, in particular a fused xerographic image, which is not easily smeared, yet is easily removed by a variety of methods.

An important aspect of the present invention is the discovery that even a relatively small amount of the polyfluorinated acrylate compound, which generally is much more expensive than the polymeric binder, provides cured compositions having a surprisingly high degree of abhesiveness. Thus, the compositions of the present invention function as a unique and comparatively inexpensive replacement for costly fluoropolymers sometimes used to provide abherent surfaces.

While we do not wish to be bound by any theory, it is thought that the ability to use small amounts of polyfluorinated acrylate to provide cured compositions having such high levels of abhesiveness is due to the ease with which the polyfluorinated acrylate compound migrates to the surface of the coating composition prior to radiation curing. Once migration of the compound to the surface has occurred it is incorporated to a high degree into the crosslinked network of the coating by radiation curing. The resultant cured coating has a highly fluorinated low adhesion exposed surface despite the fact that only a relatively small amount of polyfluorinated acrylate monomer has been utilized.

Another important aspect of the present invention is that the composition, once coated on a suitable substrate and radiation cured, provides the substrate with a coating which is abhesive on its exposed surface yet adheres tenaciously to the substrate. Thus, the abherent coatings of the present invention are not easily removed from the substrate, even by strong solvents, and can provide the substrate with an abherent surface for a relatively long period of time. The fact that the coating adheres strongly to the substrate is further support for the theory that the polyfluorinated acrylate groups are concentrated on the exposed surface of the coating composition.

The coating compositions of the present invention, once radiation cured, are highly resistant to all known solvents including such harsh solvents as tetrahydrofuran and trifluoroethanol. This property is of particular advantage when the abhesive surface is to be used with solvent based adhesives, such as in transfer adhesive systems.

The coating compositions of the present invention can be cured without the need for thermal polymerization processes. The desirability of radiation sensitive compositions has long been recognized

since the energy requirements are usually minimal when compared to those of conventional heat curing processes. In addition, conventional thermal polymerization processes require that the polymerization materials and the substrates be heat insensitive.

A still further aspect of the present invention is an image transfer system for transferring an image from a surface which has been coated with a release coating and then imaged onto a different receiver surface comprising the steps of:

(a) applying an image to a release coated surface of a first support base;

(b) adhering an adhesive surface of an adhesive coated second support base over the image on the release coated surface of the first support base;

(c) applying sufficient pressure to the second support base to effect intimate contact between the adhesive surface of the second support base and the image on the release coated surface of the first support base;

(d) separating the image bearing first support base from the second support base, with the image being transferred to the adhesive layer of the second support base;

characterized in that said release coating on said first support base is a layer of the coating compositions of the present invention which have been radiation cured; and further characterized by the feature that the process comprises an additional step.

(e) securing the adhesive layer of the second support base, now bearing the image, onto a different receiver surface by the application of pressure to provide the receiver surface with a protected image.

The image transfer process provides a method of transferring an image to a receiver surface to form imaged articles with protected messages which are not subject to adverse environmental effects such as physical and chemical contact, and are not capable of being smeared or rubbed off.

## Brief Description of Drawings

For a general understanding of the image transfer system, reference is made to the figure, wherein the sequential flow of steps is illustrated.

## Detailed Description

The polyfluorinated acrylate compound utilized in the coating compositions of the present invention contains sufficient fluorine to provide the total composition with at least 0.05% by weight fluorine. This minimum amount of fluorine is necessary to provide suitable abhesive characteristics.

The abhesive characteristics of the radiation cured coatings can be measured by a solvent based adhesive peel strength test (designated hereinafter as "180°-S-Peel"). Basically, "180°-S-Peel" strength is the force required to remove a solvent based acrylic adhesive from a substrate coated with a radiation cured abhesive coating of the present invention.

The cured coatings of the present invention generally provide abherent surfaces having "180°-S-Peel" strengths within a range taught to be useful by the prior art, i.e., between about 115 and 725 grams per centimeter (about 10 to 65 ounces per inch).

Examples of polyfluorinated acrylate compounds particularly suitable for use in the compositions of the present invention include polyfluorinated acrylates and methacrylates, and poly(fluorooxyalkylene)-acrylates and methacrylates.

Preferred polyfluorinated acrylates and methacrylates have the general formula:

$$R_f—X—A \qquad I$$

wherein:

$R_f$ is a polyfluorinate saturated, monovalent, aliphatic radical that is straight, branched or cyclic;

A is an ethylenically unsaturated group having the formula:

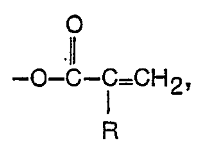

Ia

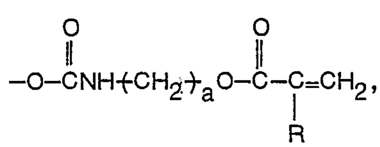

, or Ib

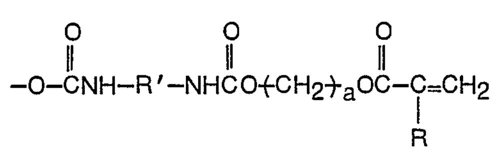

Ic

wherein:

R is hydrogen or methyl;

a is an integer having a value of 2 to 6; and

R′ is a divalent aliphatic or cycloaliphatic group having 2 to 14 carbon atoms or an aryl group having 6 to 14 carbon atoms; and

X is a connected group selected from the group consisting of:

$$-SO_2-\overset{R^2}{\overset{|}{N}}\!-\!(CH_2)_b, \qquad \text{Id}$$

$$-(CH_2)_{b'}, \text{ and} \qquad \text{Ie}$$

$$-\overset{O}{\overset{\|}{C}}-\overset{R^2}{\overset{|}{N}}\!-\!(CH_2)_b \qquad \text{If}$$

wherein:

b is 2 to 12; b′ is 1 to 12;

$R_2$ is hydrogen, an alkyl group of 1 to 4 carbon atoms (preferably methyl or ethyl), or $-(CH_2)_c-A$, wherein A is defined above,

c is 2 or 3, and wherein when $R_2$ is $-(CH_2)_c-A$, b is 2 or 3;

and when $R_f$ contains 6, 7 or more than 7 carbon atoms there are no more than 6, 10 or 20 atoms respectively in the chain between $R_f$ and A.

Preferably, $R_f$ is fully fluorinated, however, desired release characteristics can be obtained with hydrogen or chlorine atoms present as substituents in the radical provided that not more than one atom of either is present for ever two carbon atoms in the radical. $R_f$ preferably contains 6 to 14 carbon atoms, and most preferably, 8 to 10 carbon atoms.

The preferred compounds of Formula I are those compounds in which the connecting group X is

$$-SO_2-\overset{R_2}{\overset{|}{N}}\!-\!(CH_2)_b \qquad \text{(Id)}$$

The compounds of Formula I are prepared by the reaction of an $R_fOH$ or an $R_fXOH$, such as fluoroalkylsulfonamidoalkanol, a fluoroalkanol, or a fluoroalkylcarbonamidoalkanol, with the acid halide, anhydride, or lower alkyl ester of acrylic or methacrylic acid, an isocyanatoalkyl acrylate or methacrylate, or the reaction product of one mole of an organic diisocyanate and one more of a hydroxyalkyl acrylate or methacrylate.

Examples of compounds of Formula I in which X is of the Formula Id and A is of the Formule Ia are disclosed in U.S. Patent No. 2,803,615. Examples include:

3(N-methylperfluorooctanesulfonylamido)propyl acrylate,

2-(N-ethylperfluorooctanesulfonylamido)ethyl acrylate,

2-(N-ethylperfluorooctadecanesulfonylamido)ethyl acrylate, and

4-(N-butylperfluorohexanesulfonylamido)butyl methacrylate.

Examples of compounds of Formula I in which X is of the Formula Id and A is of the Formula Ib or Ic include:

3-(N-methylperfluorooctanesulfonamido)propyl 2-acryloyloxyethylcarbamate,

2-(N-ethylperfluorodecanesulfonamido)ethyl 2-acryloyloxyethylcarbamate,

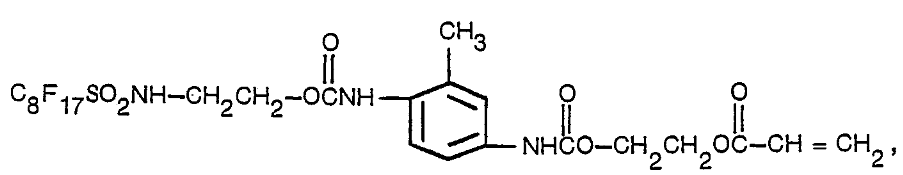

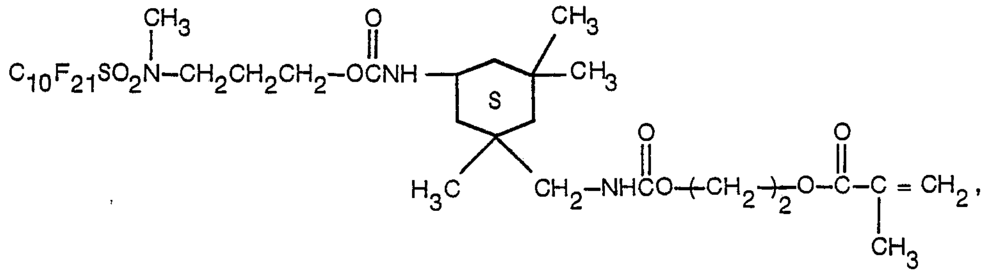 and

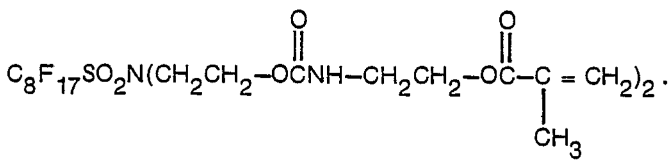

Examples of compounds of Formula I in which X is of the Formula Ie and A is of the Formula Ia are disclosed in U.S. Patent Nos. 2,642,416; 3,384,627; 3,419,602; 3,719,698; 3,981,928; 3,102,103; 3,171,861; and 3,818,074. Examples include:

3-perfluorooctylpropyl acrylate,
perfluoroheptylmethyl acrylate,
12-perfluorooctyldodecyl methacrylate,
6-perflurodecylhexyl acrylate,
3-perflurooctyl-2-chloropropyl acrylate,
3-perfluorooctylpentyl methacrylate, and
1,2,2-trihydro-1-methylheneicosafluorododecyl acrylate.

Examples of compounds of Formula I in which X is of the Formula Ie and A is of the Formula Ib or Ic include:

perfluoroheptylmethyl 2-acryloyloxyethylcarbamate,
perfluorononylmethyl 2-methacryloyloxypropylcarbamate, and

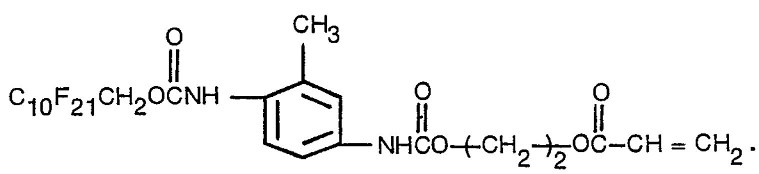

Examples of compounds of Formula I in which X is of the Formula If and A is of the Formula Ia, Ib or Ic include:

2-(perfluoroheptylcarbonamido)ethyl acrylate,

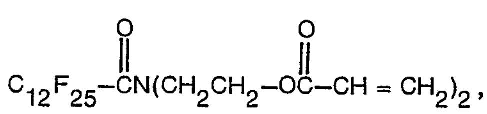

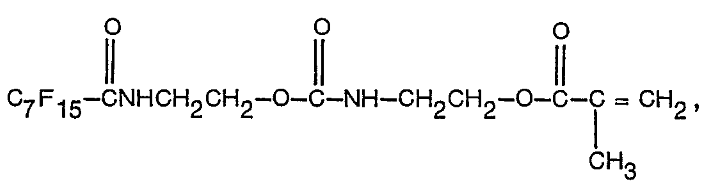 and

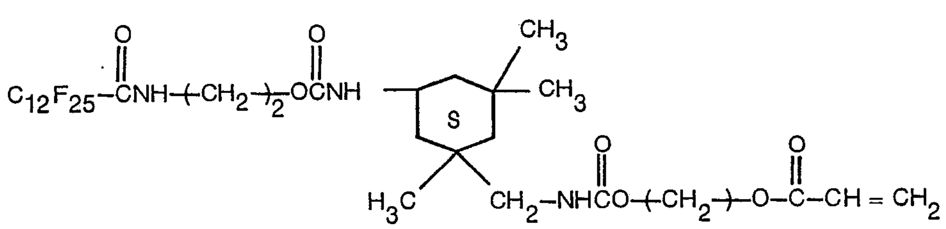

When polyfluorinated acrylates and methacrylates such as those described by Formula I are utilized, there is present in the coating composition preferably 1 to 70 percent by weight of polyfluorinated acrylate compound, more preferably 3—45 percent by weight, and most preferably 5—25 percent by weight.

Perferred poly(fluorooxyalkylene) acrylates and methacrylates have the general formula:

$$Z\,R_f^2—Y—A \qquad II$$

wherein:

A is as it was defined for Formula I, i.e. Formulas Ia, Ib and Ic;

Y is $—CH_2$ or

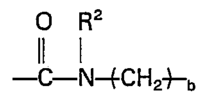

If

wherein:

b is 2 to 12, $R^2$ is hydrogen, an alkyl group of 1 to 4 carbon atoms (preferably methyl or ethyl), or $-(CH_2)_c A$, wherein A is defined above, c is 2 or 3, and wherein when $R^2$ is $-(CH_2)_c A$, b is 2 or 3;

$R_f^2$ is a divalent poly(fluorooxyalkylene) group having a number average molecular weight of from about 500 to 20,000 and, preferably, about 2,000 to 10,000, as disclosed in U.S. Patent No. 3,810,874; and

Z is $CF_3O—$, $CF_3OCF(CF_3)O—$, or —Y—A, where Y and A are defined as they were above.

$R_f^2$ preferably comprises highly fluorinated polyethers having randomly distributed units selected from $—CF_2O—$, $—CF_2CF_2O—$ and $—C_3F_6O—$, and many also have incorporated therein $—CF_2—CF_2—CF_2—CF_2—O—$, $—CF_2—$ and $—C_2F_4—$ groups. Examples of such $R_f^2$ backbones are disclosed in U.S. Patent Nos. 3,250,807; 3,250,808; 3,505,229; 3,699,145, 3,810,874; 3,810,875; 3,814,741; and 3,882,193. Most preferably $R_f^2$ comprises the unit, $—CF_2—O-(CF_2CF_2O)_m-(CF_2O)_nCF_2—$ wherein m and n are whole numbers having a value of about 1 to 200, and designate the number of randomly distributed perfluorooxyethylene and perfluorooxymethylene backbone repeating subunits, respectively, and the ratio m/n is between about 0.2/1 and 5/1.

The compounds of Formula II are prepared by the reaction of a poly(fluorooxyalkylene)methanol or a poly(fluorooxyalkylene)amidoalkanol with the acid halide, anhydride, or lower alkyl ester of acrylic or methacrylic acid, an isocyanatoalkyl acrylate or methacrylate, or the reaction product of one mole of an organic diisocyanate and one mole of a hydroxy alkyl acrylate or methacrylate.

Examples of compounds of Formula II wherein Y is $—CH_2—$, A is of the Formula Ia, and Z is $CF_3O—$ or $CF_3OCF(CF_3)O—$, are disclosed in U.S. Patent No. 3,814,741, and include:

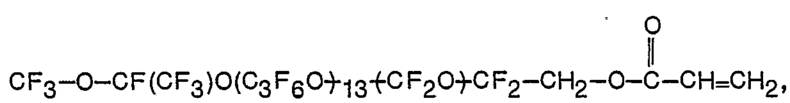

and

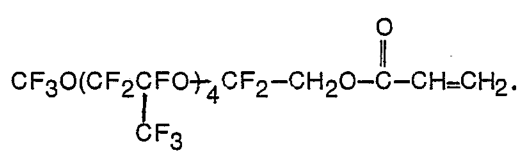

Examples of compounds of Formula II wherein Y is $—CH_2—$, A is of the Formula Ib or Ic, and Z is $CF_3O$ or $CF_3OCF(CF_3)O—$ include:

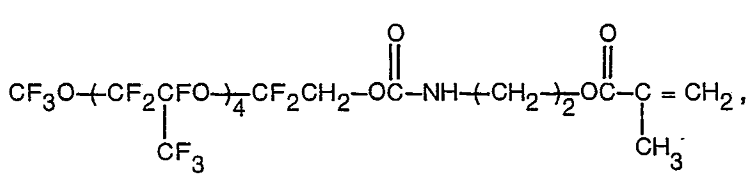

and

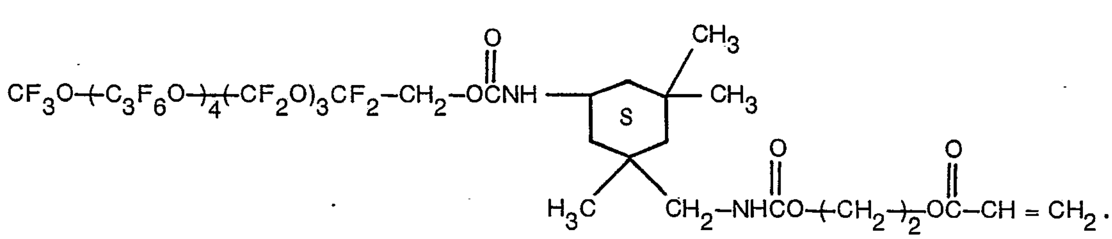

Examples of compounds of Formula II wherein Y is of the Formula If, A is of the Formula Ia, Ib or Ic, and Z is $CF_3O$— or $CF_3OCF(CF_3)O$— include:

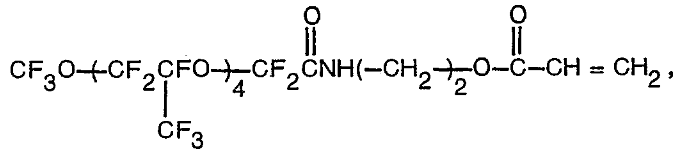

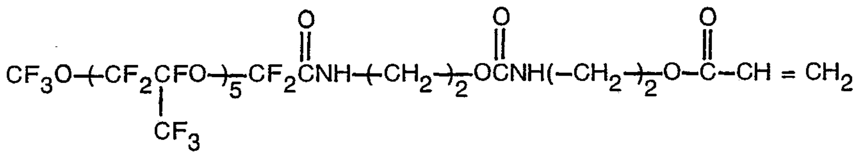

and

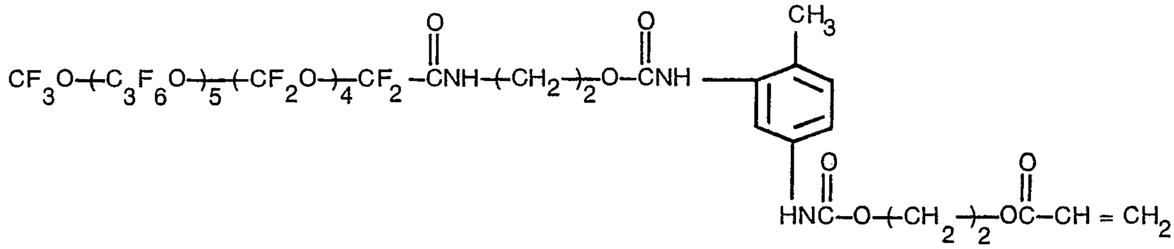

Examples of compounds of Formula II wherein Y is —$CH_2$— or of the Formula If, A is of the Formula Ia, Ib or Ic, and Z is —Y—A, where Y and A are defined as they were hereinabove, include:

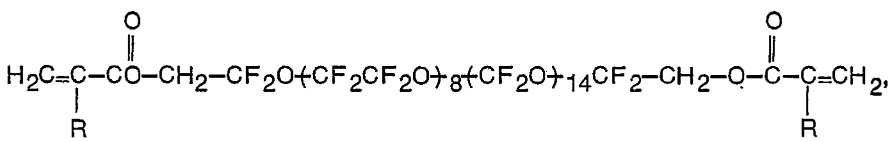

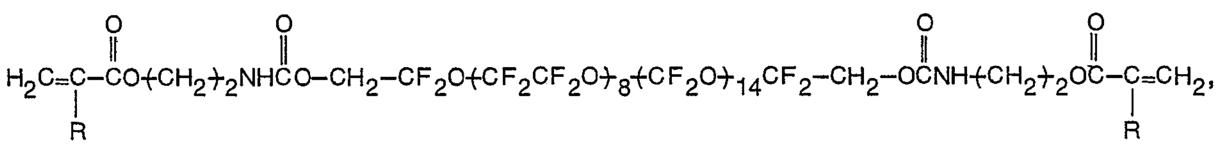

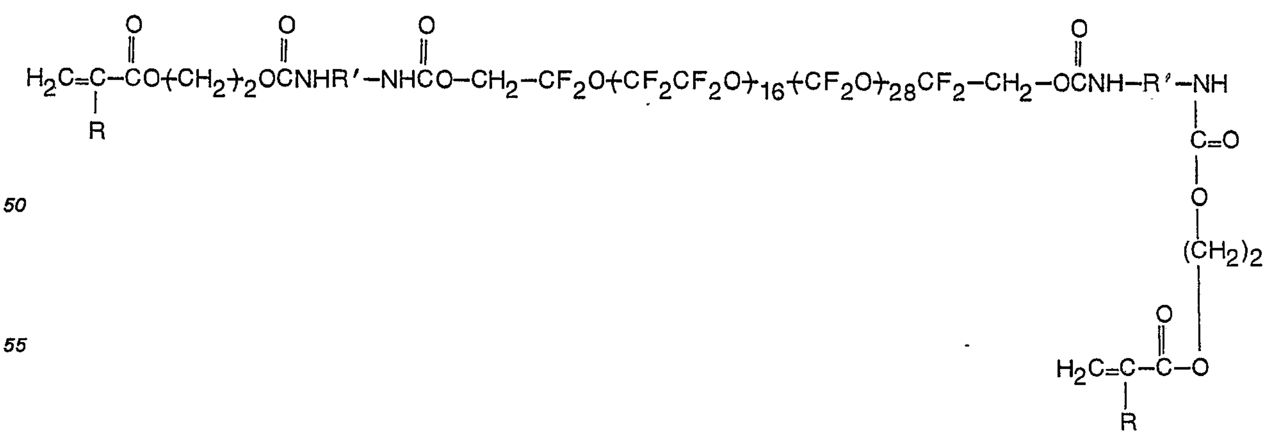

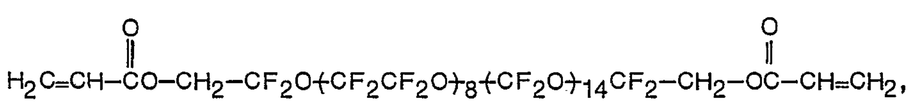

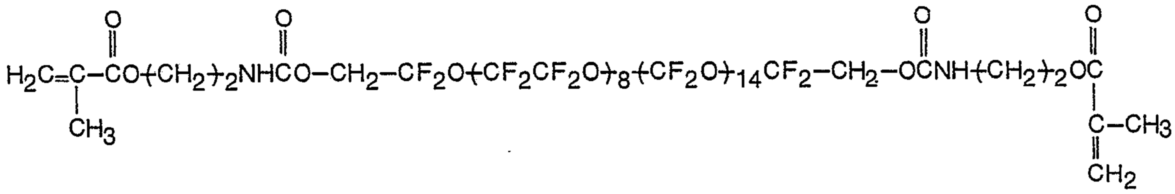

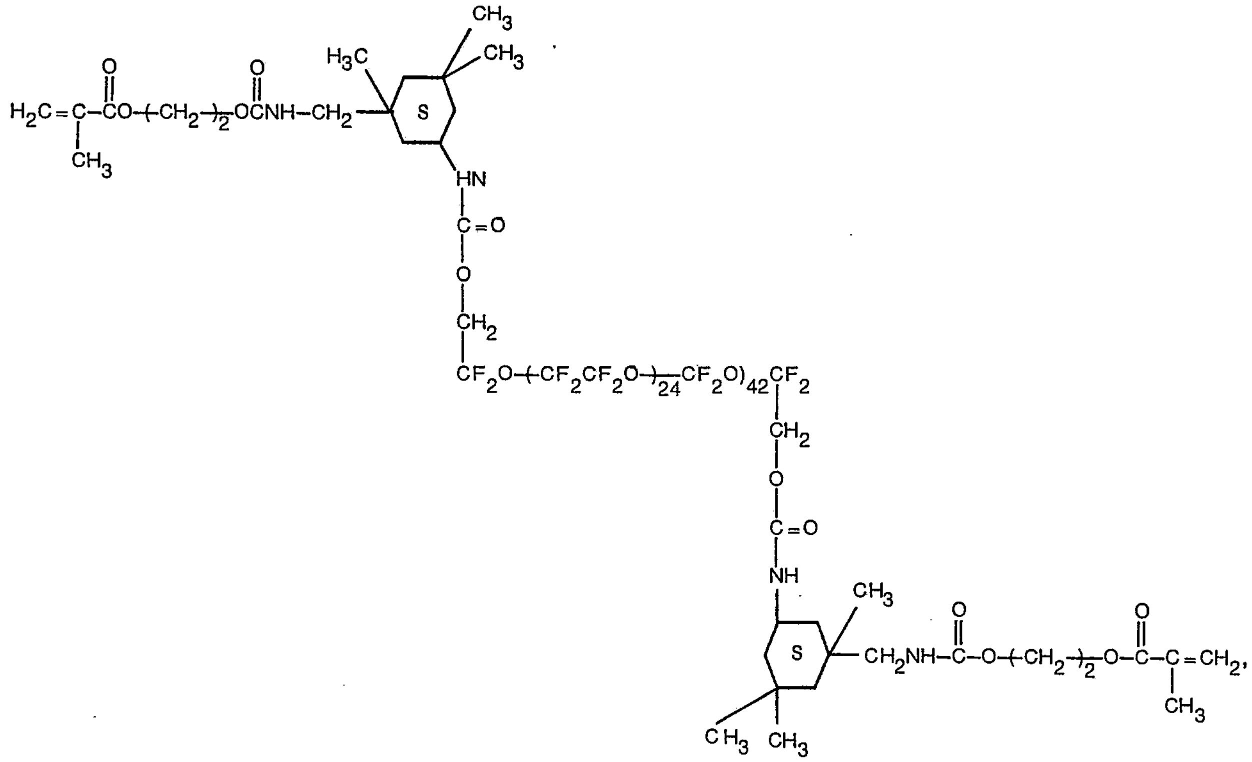

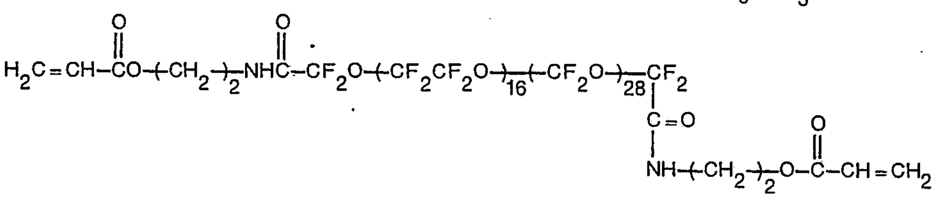

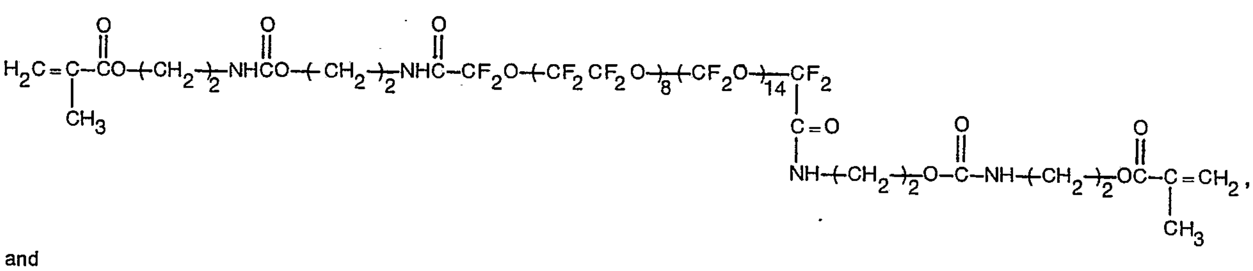

and

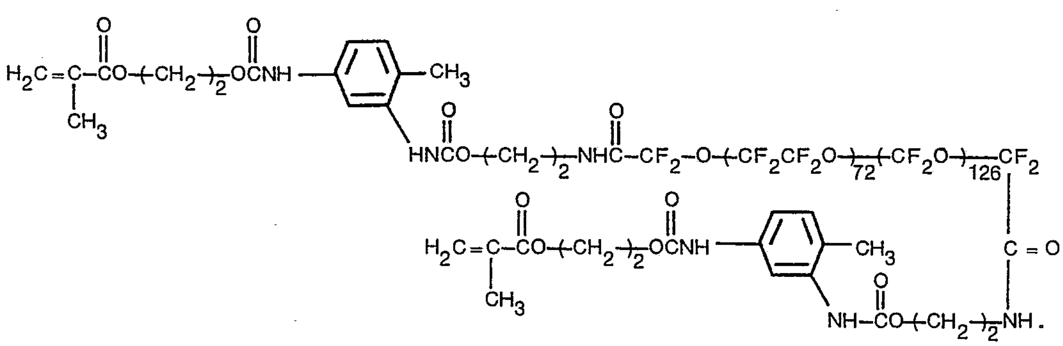

Particularly preferred poly(fluorooxyalkylene) acrylates and methacrylates are compounds of Formula II wherein A is

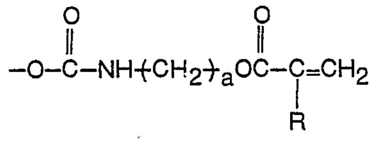 Ib

or

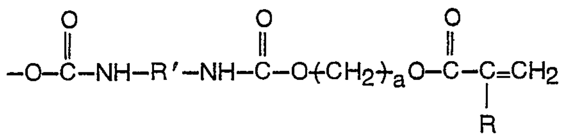 Ic

wherein a, R, and R′ are defined as above. These compounds belong to the class of poly(fluorooxyalkylene)urethane acrylate compounds, and are believed to be novel. Exemplary of these novel urethane acrylate compounds are:

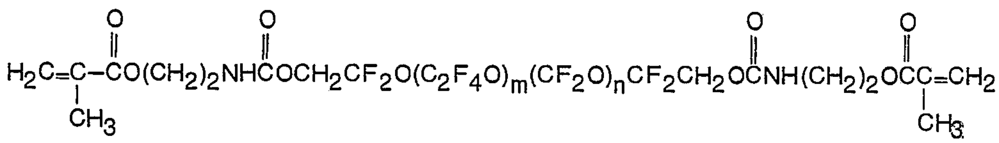

wherein m/n has an average value of about 0.5 and wherein the compound has a number average molecular weight of about 4690;

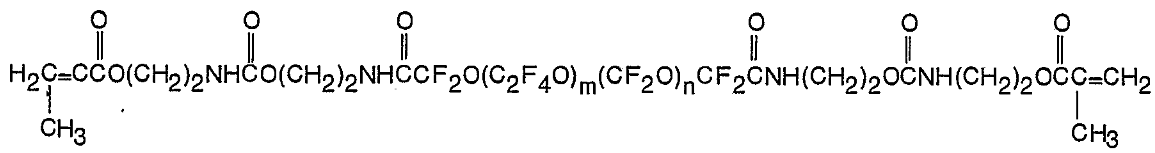

wherein m/n has an average value of about 0.6 and wherein the compound has a number average molecular weight of about 2310; and

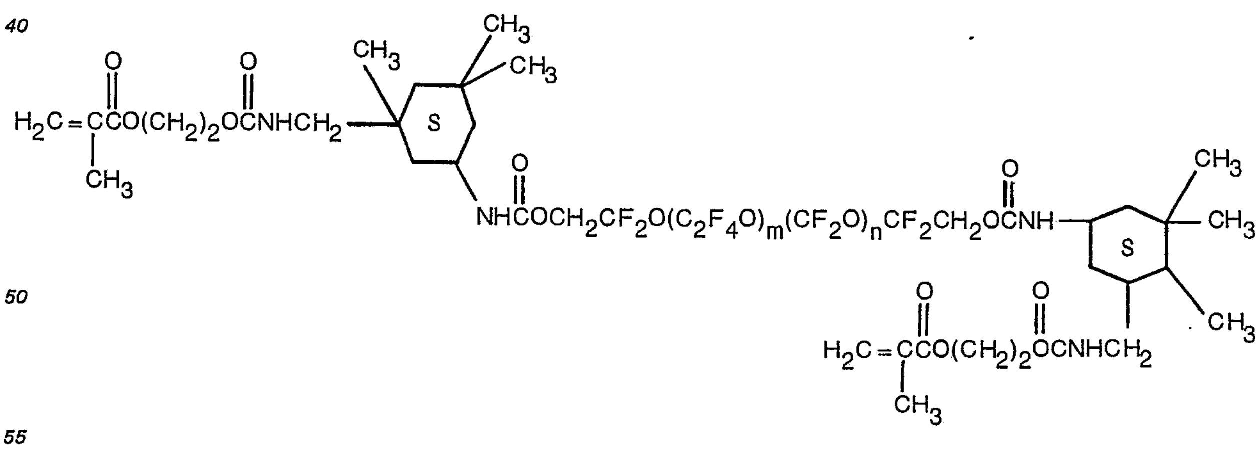

wherein m/n has an average value of about 0.5, and the number average molecular weight of the compound is about 5450. These compounds are preferred because they are easier to prepare, and therefore more economical, more compatible with the other components of the radiation curable compositions of the invention, and generally highly reactive therewith.

When the poly(fluorooxyalkylene)acrylates and methacrylates described by Formula II are utilized, there is present in the radiation curable abherent coating composition preferably 0.1 to 20 percent by weight of the polyfluorinated acrylate material, more preferably 0.15 to 10 percent by weight, and most preferably 0.2 to 5 percent by weight.

Exemplary polyethylenically unsaturated crosslinking agents for inclusion in the radiation curable

compositions of the present invention include acrylic and methacrylic substituted compounds having an acrylic equivalent weight of 63 to 275, preferably 85 to 200 and more preferably 100 to 150. Such agents are well-known and are listed, for example, in U.S. Patents 3,833,384; 3,885,964; and 4,037,021. Preferred crosslinking agents include acrylic anhydride, methacrylic anhydride, polyacrylate and polymethacrylate esters of alkenepolyols, and the polyacrylate and polymethacrylate esters of isocyanurate and *s*-triazines (e.g., tris(2-acryloyloxyethyl)isocyanurate, and 1,3,5-tri(2-methacryloxyethyl)-*s*-triazine).

Preferably, there is present in the coating compositions 10 to 62 percent by weight, more preferably 15 to 50 percent by weight and most preferably 20 to 30 percent by weight polyethylenically unsaturated crosslinking agent.

Film-forming polymers suitable for use in the compositions of the invention are generally thermoplastic organic polymers containing carbon and hydrogen and optionally oxygen, nitrogen and halogens, i.e., chlorine. In order to be of use in the present invention the film-forming polymer must be compatible and dispellable with the polyfluorinated acrylate compound. Suitable polymers are those polymers that:

1. are soluble in tetrahydrofuran; and
2. do not exhibit immediate phase separation when the polyfluorinated acrylate compound is dispelled into a solution of the polymer in tetrahydrofuran.

Examples of suitable polymers include: polyesters, e.g. polyethylene terephthalate; copolyesters, e.g. polyethylene terephthalate isophthalate; polylactones, e.g. polycaprolactone; polyamides, e.g. polyhexamethylene adipamide; vinyl polymers, e.g. poly(vinyl acetate/methyl acrylate), poly(vinylidene chloride/vinyl acetate); polyolefins, e.g. polystyrene; polydienes, e.g. poly(butadiene/styrene); polyacrylates, e.g. poly(methyl methacrylate/ethyl acrylate), poly(methyl acrylate/acrylic acid); polyurethanes, e.g. reaction products of aliphatic, cycloaliphatic or aromatic diisocyanates with polyester glycols or polyether glycols; and cellulosic derivatives, e.g. cellulose ethers such as ethyl cellulose esters such as cellulose acetate/butyrate.

Preferably, there is present in the radiation curable coating composition, 5 to 85 percent by weight, more preferably 30 to 80 percent by weight, and most preferably 50 to 70 percent by weight film-forming organic polymer.

The coating compositions are preferably prepared by dispelling the film-forming organic polymer, the polyethylenically unsaturated crosslinking agent and the polyfluorinated acrylate compound in a suitable solvent. A particularly preferred method of preparing the coating composition is by first dissolving the polymer in a suitable solvent and then adding the crosslinking agent and the polyfluorinated acrylate compound to the solution. Generally, solutions having concentrations of solids of 20 to 40 percent by weight are preferred, although higher or lower concentrations can be used, depending upon whether the viscosity of the solution is suitable for coating onto a substrate. The preferred solvent is tetrahydrofuran. Other suitable solvents include dimethyl formamide, cyclohexanone, methyl isobutyl ketone, methyl ethyl ketone, and similar polar aprotic solvents.

Various additives, such as coating aids, wetting agents, flatting agents, dyes, ultraviolet absorbers, pigments (particularly clays), particulate materials, e.g., microspheres and microballoons, can be added to the compositions of the invention in amounts and for purposes that are well known. Monoethylenically unsaturated compounds can also be incorporated to modify the flexibility and image adhesion properties of the abhesive coatings. Examples of such modifying compounds include vinyl benzoate, methacrylic acid, acrylamide, dimethyl itaconate, acrylonitrile octyl acrylate, 2-ethylhexyl acrylate, dodecyl methacrylate, octadecyl acrylate, and the like.

When visible light or ultraviolet radiation is used to cure the compositions, it is generally necessary to include a source of free radicals, i.e. a material which liberates free radicals on exposure to radiation. Such free radical sources are well known and are described in the art, e.g. "Photochemistry" by Calvert and Pitts, John Wiley & Sons, Chapter II (1966). For example, when ultraviolet radiation is utilized, suitable sources of free radicals include such compounds as acyloin and derivatives thereof, e.g. benzoin ethyl ether. Other sources of free radicals are disclosed in U.S. Patents 3,887,450; 3,895,949; 4,043,819; 3,729,313 and 4,058,401. The free radical source can be used in amounts ranging from 0.01 to 5 percent and preferably 0.25 to 1.0 percent by weight of the total composition.

When visible light is utilized as the source of actinic radiation it is generally necessary that the composition also contain, in addition to the free radical source, a sensitizer capable of absorbing radiation of a wavelength present in the visible light and transferring the absorbed energy to the free radical source. Suitable sensitizers include cyanine, merocyanines, styryl and like dyes such as are described in U.S. Patent 3,099,558.

The coating compositions of the present invention are found to be of use in providing substrates with a strongly adhering abhesive coating. Such substrates include metal, e.g. steel, nickel, aluminum; plastics, e.g., polyester, polycarbonate, polymethyl methacrylate, polyvinyl chloride, polyurethane, epoxy resins, phenolformaldehyde resins, etc; rubber, wood, paper, glass, ceramic, and the like. In order to coat some substrates, such as polyester films, it is necessary to use primers, as is well known in the art.

After the coating composition is applied to the substrate by any of the techniques known in the art, such as, for example, spray, brush, dip, knife, curtain and the like coating processes, it can be cured by exposure to actinic radiation, i.e., visible light, ultraviolet, laser beam, electron beam, X-rays, gamma rays

and the like. Preferably, the coatings are cured by exposure to an electron beam such as is provided by electron-curtain processors.

A particularly preferred use of the coating compositions of the present invention is in an image transfer process as previously described. The abhesive coating composition is coated on a first support base in normal fashion and exposed to an electron beam. The abhesive coated first support base can then be imaged. The adhesive surface of an adhesive coated second support base can then be pressed onto the image, whereupon the image transfers to the adhesive surface. The adhesive surface can then be applied to other receiver surfaces to provide these surfaces with a protected image. The image to be transferred may be applied to the release coated surface of the first support base by a variety of means such as xerographic printing, silk screening, stenciling and other mechanical, electrical or chemical techniques such as electrography, and electrophotography.

The radiation cured abhesive coating compositions of the present invention, are of particular use when the imaging means is xerographic, since they are able to carry a fused xerographic image which is not easily smeared, such as by finger pressure, yet which can be easily removed by an adhesive surface.

The second support base which is contacted with the imaged first support base can comprise a transparent, translucent, or opaque material which is coated with either a pressure sensitive adhesive or a latent adhesive surface. The second support base can be selected from materials such as are suitable for the first support base including paper, metals, e.g., aluminum, and plastics, e.g., polyethylene, polyester, and polyvinylchloride. Exemplary of useful pressure sensitive adhesives are polyacrylate adhesives, repositionable microsphere acetate tape, and rubber adhesives. Exemplary of useful latent adhesives is the friction activatable adhesive disclosed in U.S. Patent No. 4,066,600.

The pressure sensitive adhesive surface or activated latent adhesive surface of the second support base is applied to the imaged first support base, and pressure, such as finger pressure, is applied to the composite structure. When the second support base is separated from the first support base the image originally applied to the release coated first support base is transferred to the adhesive layer on the second support base. The abhesive coatings of the present invention enable an image, in particular, a fused xerographic image, which has been applied to the coating to be removed completely by the adhesive surface of the second base support.

The second support base bearing the image may be used in a variety of applications such as labels, decals, transparencies, appliques, and other informative displays, on receiver surfaces. Typical receiver surfaces include walls, automobiles, windows, books, etc. The adhesive coated, image bearing surface of the second support base is applied to the receiver surface. The second support base adheres to the receiver surface and provides the receiver surface with a protected message. Where the receiver surface is a transparent or translucent surface, such as a window, and the protected image is to be viewed through the receiver surface, the second support base may be transparent, translucent or opaque. Where the receiver surface is opaque and the protected image is to be viewed through the second support base, the second support base must be transparent or translucent.

In order to more clearly disclose the nature of the present invention, the following examples are presented. It should be understood, however, that these examples are intended neither to delineate the scope of the invention nor limit the ambit of the appended claims. In the examples, the process of preparing the coating compositions described above, was employed, and the quantities of material are expressed in terms of percentages by weight of the total composition, unless otherwise specified.

Examples 1—10

Mixtures of 4 g of each film-forming polymer listed in Table I, 1 g of N-ethylheptadecafluorooctanesulfonamidoethyl acrylate (NEF), prepared according to the procedures described hereinabove, and 4 g of tris(2-acryloxyethyl)isocyanurate were dissolved in sufficient tetrahydrofuran to provide a readily coatable solution having a concentration of solids of between about 20 and 40 percent by weight. Each solution was knife coated onto umprimed 35.56 μm (1.4 mil) polyester film and onto 101.6 μm (4 mil) polyester film that had been primed with polyvinylidene chloride. The solvent was allowed to evaporate at room temperature for about one hour and the coating was cured by exposure to accelerated electrons in an electron curtain processor to 16 M Rad at 175,000 electron volts (ev) at a web speed of 7.6 meters per minute under nitrogen atmosphere. The abhesive character of the coatings was measured as peel adhesion i.e., the force required to remove an adhesive coated tape from the abhesive coating on primed polyester. A peel strength test was performed by knife coating, at a thickness of 203.2 μm (8 mils), a 25% solution of an adhesive comprising 95.5 percent by weight poly(isooctyl)acrylate and 4.5 percent by weight acrylic acid in an 80:20 percent by volume mixture of heptane and isopropyl alcohol, onto the particular electron beam cured abhesive coating. The solvent was removed by maintaining the adhesive coating at room temperature for approximately 24 hrs., followed by five minutes at 65°C. Unprimed polyester, about 35.56 μm (1.4 mil) thick and 2.54 cm wide, was then pressed with a 2 kg roller onto the adhesive coated surface. "180°-S-Peel" is the force required to remove this resultant adhesive tape using an attached spring scale at a rate of about 4 cm/sec such that the portion of tape removed comes back adjacent but not quite touching the portion still attached to the coating. For further explanation of the "180°-S-Peel" test, see U.S. Patent 4,157,418. The values of the "180°-S-Peel" test are recorded in Table I and are within a range taught to be useful by the prior art, i.e., between about 115 and 725 grams per centimeter. The values obtained in the "180°-S-Peel"

tests illustrate that the cured coatings having a high degree of abhesiveness despite the relatively small amount of polyfluorinated acrylate compound utilized. It should be noted that the data reported in Table I is the average of two or three trials.

Any alteration of the adhesive character of the tape after contact with an abhesive surface was determined by a "Readhesion" test. This test was performed with the adhesive coated tape resulting from the "180°-S-Peel" test by pressing it onto a glass plate that has been cleaned by wiping with diacetone alcohol, and then heptane. The force required to remove the tape by the method described for the "180°-S-Peel" test is the "Readhesion" force. Readhesion values with the solvent based acrylic adhesive, (designated "S-Readhesion") of less than about 40 oz/in (445 g/cm) after contact with the abhesive surface tend to indicate that the adhesive surface was contaminated with abhesive material removed from the abhesive coated layer. The values of 'S-Readhesion" recorded in Table I indicate that the adhesive surfaces were not contaminated with abhesive materials. This lack of contamination by the abhesive material illustrates that the components of the abhesive compositions, after curing, are highly incorporated into the crosslinked network.

"Extractable %" was measured by removing a portion of each cured abherent coating from an unprimed polyester substrate, weighing it, and extracting it with tetrahydrofuran at room temperature for 24 hours. The insoluble residues were dried and weighed and the percent of extracted material was calculated. The insoluble residue was then analyzed for fluorine content according to the procedure described in Analytical Chemistry, *41* 107 (1969), and the amount of polyfluorinated acrylate incorporated into the cured coating, designated F. C. Inc. (fluorine compound incorporated) in Table I, as a percentage of that originally present in the coating composition was calculated. The "Extractable %" reported in Table I illustrates the solvent resistance (even in a strong solvent such as tetrahydrofuran) of the cured abhesive coatings, since very little of the coating material was extractable. The values of "F. C. Inc." indicate that in most cases almost all of the polyfluorinated acrylate that was originally present in the coating composition was incorporated in the crosslinked network of the cured coating.

TABLE I

| Ex. No. | Film Forming Polymer | Extractable % | F. C. Inc. % | 180°-S-Peel g/cm | S-Readhesion g/cm |
|---|---|---|---|---|---|
| 1. | Poly(MMA/EA/AA [a] | 4.3 | 93.8 | 425 | 470 |
| 2. | Polycaprolactone triol | * | * | 380 | 485 |
| 3. | Poly(MMA/EA) [b] | 20.0 | 92.4 | 435 | 470 |
| 4. | [c] | 18.1 | 91.0 | 485 | 470 |
| 5. | Poly(styrene/isoprene — 20/80) | 7.7 | 95.9 | 390 | 485 |
| 6. | Poly(epichlorohydrin-ethyleneoxide) | 8.8 | 99.8 | 445 | 560 |
| 7. | Polyesterurethane | 1.2 | 98.8 | 600 | 670 |
| 8. | Polyisoprene | 1.9 | 99.8 | 460 | 470 |
| 9. | Poly(styrene/acrylo-nitrile) | 8.9 | 97.2 | 600 | 435 |
| 10. | Ethyl cellulose | 5.3 | 93.7 | 420 | 460 |

[a] Carboset® 525 a methyl methacrylate-ethyl acrylate polymer containing 15 mole percent of acrylic acid
[b] Poly(methyl methacrylate/ethyl acrylate—53/47)
[c] Monoethyl ester of poly(methylvinyl ether/maleic anhydride)

Examples 11—32

The coating procedures of Examples 1—10 were repeated using the poly(fluorooxyalkylene)acrylates listed in Table II in the quantities indicated. The poly(fluorooxyalkylene)acrylates were prepared according to the procedures described hereinabove. Once coated on primed polyester, the coatings were exposed to 16 M Rad of electron beam radiation at 175,000 electron volts at a web speed of 7.6 meters per minute under a nitrogen atmosphere. "180-S-Peel" tests were performed on the cured coatings and the values obtained are recorded in Table II. The "180-S-Peel" strength values illustrate that the cured coatings have a high degree of abhesiveness despite the relatively small amount of poly(fluorooxyalkylene) acrylate utilized.

TABLE II

| Ex. No. | Fluorocarbon Acrylate | | Film-Forming Polymer | | Crosslinking Agent | | 180°—S—Peel |
|---|---|---|---|---|---|---|---|
| | Compound* | Parts (Wt %) | Compound | Parts (Wt %) | Compound | Parts (Wt %) | g/cm |
| 11 | A | 2.20 (11.0) | Polyesterurethane | 8.88 (44.6) | Tris(2-acryloxyethyl)-isocyanurate | 8.85 (44.4) | 300 |
| 12 | B | 2.20 (11.0) | ,, | 8.88 (44.6) | ,, | 8.85 (44.4) | 155 |
| 13 | B | 0.44 ( 2.5) | ,, | 8.4 (47.5) | ,, | 8.85 (50.0) | 110 |
| 14 | C | 2.20 (11.0) | ,, | 8.88 (44.6) | ,, | 8.85 (44.4) | 265 |
| 15 | D | 2.00 (10.0) | ,, | 12.0 (60.0) | ,, | 6.0 (30.0) | 425 |
| 16 | E | 2.00 (10.0) | ,, | 12.0 (60.0) | ,, | 6.0 (30.0) | 455 |
| 17 | F | 5.65 (23.9) | ,, | 12.0 (50.7) | ,, | 6.0 (25.4) | 390 |
| 18 | G | 2.00 (10.0) | ,, | 12.0 (60.0) | ,, | 6.0 (30.0) | 155 |
| 19 | G | 1.02 ( 5.4) | ,, | 12.0 (63.1) | ,, | 6.0 (31.5) | 165 |
| 20 | G | 0.50 (2.7) | ,, | 12.0 (64.9) | ,, | 6.0 (32.4) | 165 |
| 21 | G | 0.254 ( 1.4) | ,, | 12.0 (65.7) | ,, | 6.0 (32.9) | 200 |
| 22 | G | 0.104 ( 0.6) | ,, | 12.0 (66.3) | ,, | 6.0 (33.1) | 245 |
| 23 | G | 0.054 ( 0.3) | ,, | 12.0 (66.5) | ,, | 6.0 (33.2) | 290 |
| 24 | G | 0.018 ( 0.1) | ,, | 12.0 (66.6) | ,, | 6.0 (33.3) | 615 |
| 25 | H | 2.00 (10.0) | ,, | 12.0 (60.0) | ,, | 6.0 (30.0) | 355 |
| 26 | H | 1.007 ( 5.3) | ,, | 12.0 (63.1) | ,, | 6.0 (31.6) | 290 |
| 27 | H | 0.516 ( 2.8) | ,, | 12.0 (64.8) | ,, | 6.0 (32.4) | 425 |
| 28 | H | 0.110 ( 0.6) | ,, | 12.0 (66.3) | ,, | 6.0 (33.1) | 380 |

TABLE II (Continued)

| Ex. No. | Fluorocarbon Acrylate | | Film-Forming Polymer | | Crosslinking Agent | | 180°–S–Peel |
|---|---|---|---|---|---|---|---|
| | Compound* | Parts (Wt %) | Compound | Parts (Wt %) | Compound | Parts (Wt %) | g/cm |
| 29 | H | 0.055 ( 0.3) | Polyesterurethane | 12.0 (66.5) | Tris(2-acryloxyethyl) isocyanurate | 6.0 (33.2) | 345 |
| 30 | H | 0.027 (0.15) | ,, | 12.0 (66.57) | ,, | 6.0 (33.28) | 455 |
| 31 | I | 0.111 (0.5) | ,, | 12.0 (66.3) | ,, | 6.0 (33.1) | 290 |
| 32 | J | 2.00 (10.0) | ,, | 12.0 (60.0) | ,, | 6.0 (30.0) | 425 |

A is 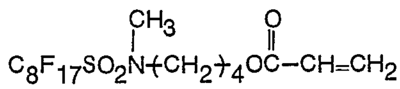

B is 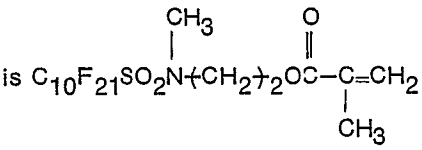

C is 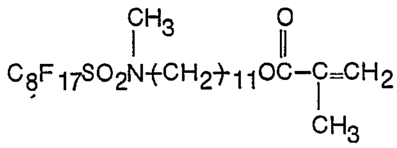

D is 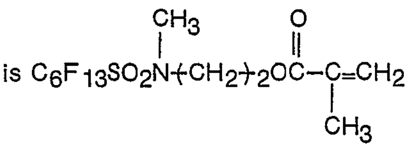

E is 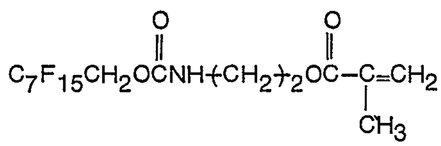

F is 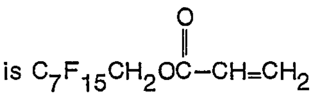

G is 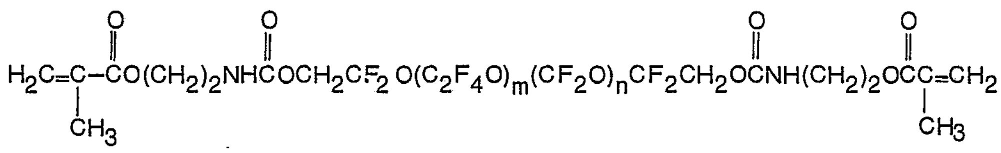

wherein m/n has an average value of about 0.5 and wherein the compound has a number average molecular weight of about 4690;

H is 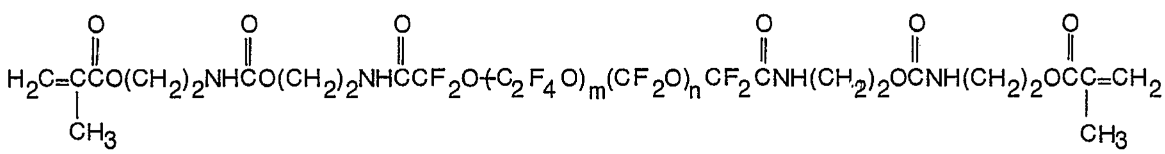

wherein m/n has an average value of about 0.6 and wherein the compound has a number average molecular weight of about 2310; and

I is

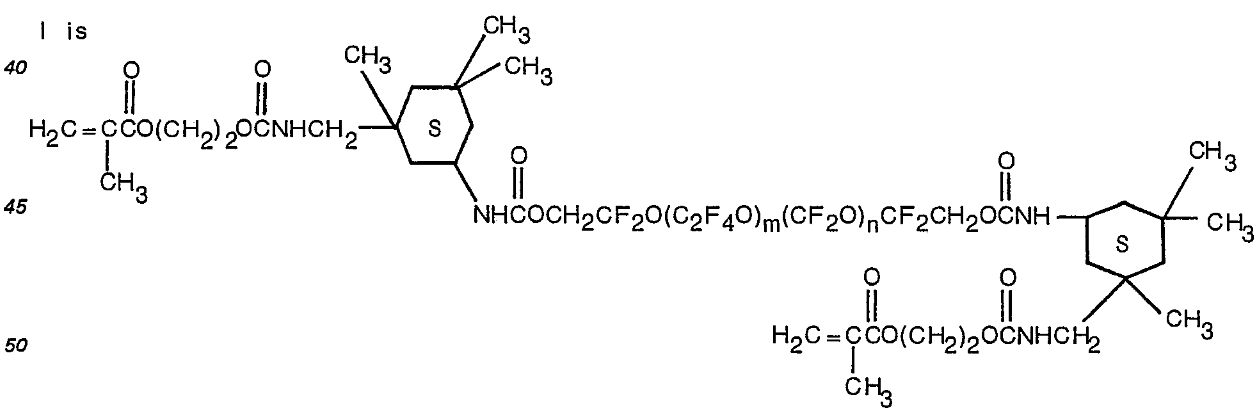

wherein m/n has an average value of 0.5 and the number average molecular weight of the compound is about 5450.

J. is 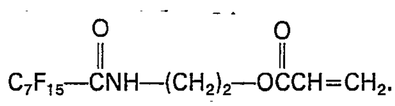

Examples 33—49

Abherent coatings were prepared as recorded in Table III according to the procedures of Examples 1—10. The coating compositions of Examples 33, 34, 38, 40, 42, 44, 46, 48 and 49 containing no crosslinking agent. The coating compositions of Examples 33 and 37 contained no polyfluorinated acrylate. The results of "180°-S-Peel" strength and "S-Readhesion" tests performed on the cured coating compositions on primed polyester are also recorded in Table III.

TABLE III

| Ex. No. | Film-Forming Polymer Parts | (wt %) | Polyfluorinated methacrylate (NEF) Parts | (wt %) | Crosslinking agent Tris(2-acryloxyethyl) isocyanurate Parts | (wt %) | 180°–S–Peel g/cm) | S–Readhesion g/cm |
|---|---|---|---|---|---|---|---|---|
| 33* | Polyesterurethane | | | | | | | |
| | 4 | (100.0) | 0 | (0.0) | 0 | (0.0) | (2) | – |
| 34* | ,, 4 | (80.0) | 1 | (20.0) | 0 | (0.0) | (2) | – |
| 35 | ,, 7 | (70.0) | 1.5 | | 1.5 | (15.0) | 400 | 360 |
| 36 | ,, 4 | (44.4) | 1 | (11.1) | 4 | (44.5) | 325 | 625 |
| 37* | ,, 4 | (50.0) | 0 | (0.0) | 4 | (50.0) | (2) | – |
| 38* | Poly(MMA/n-BuMA) [d] | | | | | | | |
| | 4 | (80.0) | 1 | (20.0) | 0 | (0.0) | (2) | – |
| 39 | ,, 4 | (30.8) | 1 | (7.7) | 8 | (61.5) | 490 | 445 |
| 40* | Chlorinated Polypropylene | | | | | | | |
| | 4 | (80.0) | 1 | (20.0) | 0 | (0.0) | (2) | – |
| 41 | ,, 4 | (30.8) | 1 | (7.7) | 8 | (61.5) | 425 | 470 |
| 42* | Poly(styrene/MMA) [e] | | | | | | | |
| | 4 | (80.0) | 1 | (20.0) | 0 | (0.0) | (2) | – |
| 43 | ,, 4 | (30.8) | 1 | (7.7) | 8 | (61.5) | 635 | 490 |
| 44* | Cl natural rubber | | | | | | | |
| | 4 | (80.0) | 1 | (20.0) | 0 | (0.0) | (2) | – |
| 45 | Cl natural rubber | | | | | | | |
| | 4 | (30.8) | 1 | (7.7) | 8 | (61.5) | 725 | 490 |

TABLE III (Continued)

| Ex. No. | Film-Forming Polymer | | | Polyfluorinated methacrylate (NEF) | | Crosslinking agent Tris(2-acryloxyethyl) isocyanurate | | 180°–S–Peel | S–Readhesion |
|---|---|---|---|---|---|---|---|---|---|
| | | Parts | (wt %) | Parts | (wt %) | Parts | (wt %) | g/cm | g/cm |
| 46* | Poly(styrene/isoprene–20/80) | | | | | | | | |
| | | 4 | (80.0) | 1 | (20.0) | 0 | (0.0) | (2) | – |
| 47 | ,, | 4 | (44.4) | 1 | (11.1) | 4 | (44.5) | 390 | 485 |
| 48* | Poly(vinylidene chloride/ acrylonitrile) | | | | | | | | |
| | | 4 | (80.0) | 1 | (20.0) | 0 | (0.0) | 770 | 370 |
| 49* | Polyvinylacetate | | | | | | | | |
| | | 4 | (80.0) | 1 | (20.0) | 0 | (0.0) | (1) | 335 |

(1) Adhesive splits between coating and support.

(2) Adhesive adheres to the coating (i.e., separates from the polyester support layer).

[d] a methyl methacrylate-butylmethacrylate polymer (73/27).

[e] a styrene-methyl methacrylate polymer (75/25).

Examples 33, 34, 37, 38, 40, 42, 44, 46, 48 and 49, marked with an asterisk, are comparative examples and illustrate that the coating compositions of the present invention must comprise both polyfluorinated acrylate and crosslinking agent in order to provide cured abherent coatings having useful release characteristics, i.e., "180°-S-Peel" of 115 to 725 g/cm (10 to 65 ounces/inch).

Examples 39, 41, 43 and 45 illustrate that for the polymers utilized in those examples more crosslinker is required to produce cured coatings with useful abhesive strengths than is the case with the polvmers utilized in the other examples.

Examples 50—55

Abherent coating compositions were prepared according to the procedures of Examples 1—10, containing 15% by weight Tis(2-acryloxyethyl)isocyanurate, and varying concentrations of NEF and polyesterurethane, as indicated in Table IV. "180-S-Peel" was determined for each cured coating composition coated on primed polyester (Table IV).

Table IV

| Ex. No. | Polyesterurethane (% by weight) | NEF (% by weight) | "180-S-Peel" (g/cm) |
|---|---|---|---|
| 50 | 83 | 2 | 335 |
| 51 | 80 | 5 | 370 |
| 52 | 75 | 10 | 380 |
| 53 | 65 | 20 | 335 |
| 54 | 55 | 30 | 335 |
| 55 | 50 | 35 | 330 |

Table IV illustrates that only a small amount of the polyfluorinated acrylate, N-ethylheptadecafluorooctanesulfonamidoethyl acrylate (NEF) is required to prepare abherent coatings having useful "180-S-Peel" strengths.

Example 56

Preparation of

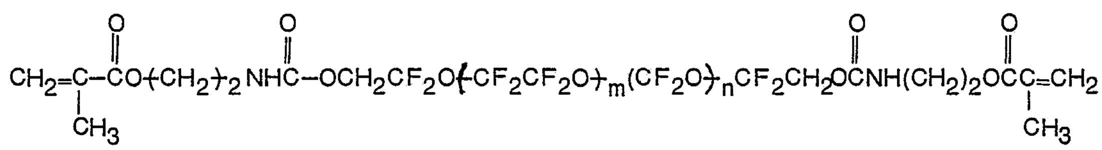

wherein the product comprises a mixture in which m/n has an average value of about 0.5 and the number average molecular weight of the compound is about 4690. Into a 100 ml flask equipped with a mechanical stirrer and a drying tube was placed 43.6 g of

$$HOCH_2CF_2O(CF_2CF_2O)_m(CF_2O)_nCF_2CH_2OH,$$

wherein the dihydroxy material comprises a mixture in which m/n has an average value of about 0.5 with the resultant OH equivalent weight being 2180, and 3.1 g of 2-isocyanatoethyl methacrylate. Stirring yielded a heterogeneous mixture. Dibutyl tin dilaurate (0.055 g) was then added to the stirring mixture and after 4—5 minutes a slight exotherm was noted. Stirring was continued for 1—2 hours. The resultant product was clear and colorless. Infrared spectra confirmed the structure of the product and indicated that it contained no unreacted isocyanate.

Example 57

Preparation of

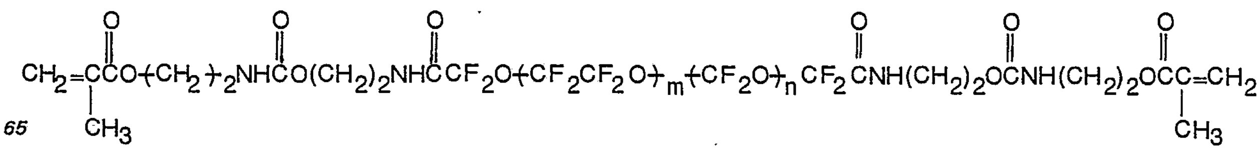

wherein the product comprises a mixture in which m/n has an average value of about 0.6 and the number average molecular weight of the compound is about 2310.

According to the procedure of Example 56, 40.0 g of

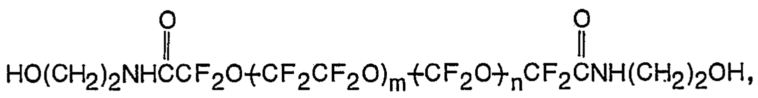

wherein m/n has an average value of about 0.6 and a number average molecular weight of about 2000, and 6.5 g of 2-isocyanatoethyl methacrylate were mixed. Dibutyl tin dilaurate (0.088 g) was then added to the mixture as in Example 56, and the mixture was cooled in an ice/water bath until the exothermic reaction subsided, about 30 min. Infrared analysis confirmed the structure of the product.

Example 58

Preparation of

$$X—OCH_2CF_2O(CF_2CF_2O)_m(CF_2O)_nCF_2CH_2O—X,$$

wherein X is

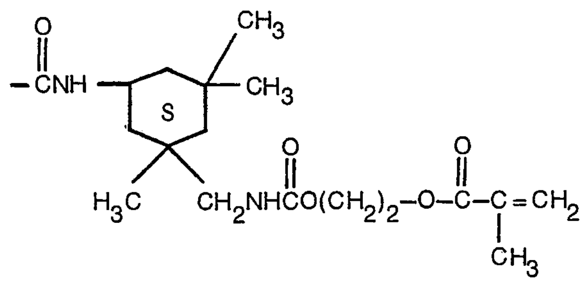

and wherein the product comprises a mixture in which m/n has an average value of about 0.5 and the number average molecular weight of the compound is about 5450. Into a 100 ml flask equipped with a mechanical stirrer and a drying tube was placed 21.8 g of

$$HOCH_2CF_2-(CF_2CF_2O)_m-(CF_2O)_nCF_2CH_2OH$$

(as in Example 56), 5.5 g of

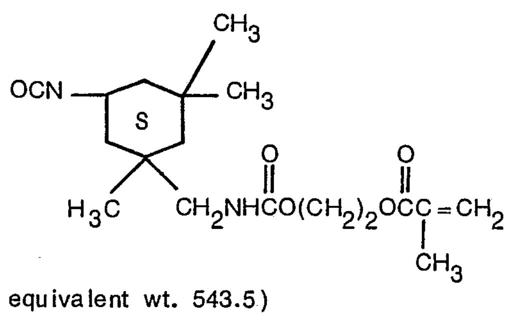

(NCO equivalent wt. 543.5)

and 0.055 g of dibutyl tin dilaurate. The mixture was stirred and heated to about 65°C (oil bath temperature) for a period of 1.5—2 hours. The structure of the product was confirmed by infrared spectral analysis which also indicated that no unreacted isocyanate remained.

Examples 59—94

Mixtures of N-ethylheptadecafluorooctanesulfonamidoethyl acrylate (NEF), tris(2-acryloxyethyl)-isocyanurate, and polyesterurethane were prepared according to the procedures described hereinabove. The components were dissolved in sufficient tetrahydrofuran to provide a readily coatable solution. Each solution was knife coated (2 ml orafice) onto clay coated Kraft paper (35.38 kg≡78 lbs) available from the Boise Cascade Co. Following solvent evaporation, the coated papers were radiation cured by exposure to accelerated electrons in an electron curtain processor to 16 MRad at 175 Kev. Each release coated paper was imaged with a fused xerographic image by use of a bond paper copier. An acrylic based pressure sensitive adhesive tape was applied to the imaged surface, followed by rubbing in the area of the image and removal of the tape, now bearing the image.

Table V illustrates the coating compositions and their use in the image and transfer process of the present invention. The column of Table V entitled "Image and Transfer" indicates the quality of the resultant image on the pressure sensitive adhesive tape, i.e., the uniformity of image density, and the tendency for the image to smear.

The columns of Table V entitled "Curled" and "Brittle" indicate whether the paper coated with the particular release coating curled or became brittle after it passed through the bond paper copier.

TABLE V

Release Coating Composition and Operation

| Example No. | NEF (% by wt.) | Polyester-urethane (% by wt.) | Tris(2-acryloxyethyl)-isocyanurate (% by wt.) | Image and Transfer | Curled | Brittle |
|---|---|---|---|---|---|---|
| 59 | 3.0 | 44.5 | 52.5 | Good | Yes | Yes |
| 60 | 4.0 | 66.0 | 30.0 | Good | Slightly | No |
| 61 | 5.0 | 80.0 | 15.0 | Good | No | No |
| 62 | 5.0 | 75.0 | 20.0 | Good | No | No |
| 63 | 5.0 | 70.0 | 25.0 | Good | Slightly | No |
| 64 | 5.0 | 60.0 | 35.0 | Good | Slightly | No |
| 65 | 5.0 | 55.0 | 40.0 | Good | Slightly | No |
| 66 | 7.0 | 63.0 | 30.0 | Good | Slightly | No |
| 67 | 7.0 | 44.5 | 48.5 | Good | Slightly | No |
| 68 | 10.0 | 80.0 | 10.0 | Good | No | No |
| 69 | 10.0 | 75.0 | 15.0 | Good | No | No |
| 70 | 10.0 | 70.0 | 20.0 | Good | No | No |
| 71 | 10.0 | 60.0 | 30.0 | Good | No | No |
| 72 | 10.0 | 55.0 | 35.0 | Good | Sightly | No |
| 73 | 10.0 | 65.0 | 25.0 | Good | No | No |
| 74 | 10.0 | 30.0 | 60.0 | Good | Yes | Yes |
| 75 | 15.0 | 65.0 | 20.0 | Good | No | No |
| 76 | 15.0 | 60.0 | 25.0 | Good | Yes | Yes |

TABLE V (Continued)

| Example No. | NEF (% by wt.) | Polyester-urethane (% by wt.) | Tris(2-acryloxyethyl)-isocyanurate (% by wt.) | Image and Transfer | Curled | Brittle |
|---|---|---|---|---|---|---|
| 77 | 15.0 | 55.0 | 30.0 | Good | No | No |
| 78 | 15.0 | 35.0 | 50.0 | Good | Yes | Yes |
| 79 | 20.0 | 60.0 | 20.0 | Good | Slightly | No |
| 80 | 20.0 | 55.0 | 25.0 | Good | No | No |
| 81 | 20.0 | 50.0 | 30.0 | Good | No | No |
| 82 | 25.0 | 35.0 | 40.0 | Good | Yes | No |
| 83 | 25.0 | 30.0 | 45.0 | Good | Yes | SL. |
| 84 | 30.0 | 55.0 | 15.0 | Good | Slightly | No |
| 85 | 30.0 | 40.0 | 30.0 | Good | Slightly | No |
| 86 | 35.0 | 44.5 | 20.5 | Marginal | No | No |
| 87 | 40.0 | 40.0 | 20.0 | Good | Slightly | No |
| 88 | 40.0 | 30.0 | 30.0 | Good | Slightly | No |
| 89 | 20.0 | 60.0 | 20.0 | Good | Yes | Yes |
| 90 | 30.0 | 60.0 | 10.0 | Good | Yes | Yes |
| 91 | 50.0 | 10.0 | 40.0 | Good | No | No |
| 92 | 60.0 | 20.0 | 20.0 | Good | Yes | No |
| 93 | 60.0 | 30.0 | 10.0 | Good | Yes | Yes |
| 94 | 70.0 | 15.0 | 15.0 | Good | Yes | Yes |

Good — 100% of the fused xerographic image was transferred to the tape.

Marginal — 90% of the image was transferred.

Examples 95—102

Release surfaces were obtained or prepared according to the procedures described hereinbelow. The release coating components of Examples 37—44 (see Table VI) were dissolved in tetrahydrofuran, knife coated onto clay-coated Kraft paper, and radiation cured, as in Examples 1—36.

Each release coating was imaged with a fused xerographic image by use of a bond paper copier (the type of copier is indicated in Table VI). An acrylic based pressure sensitive adhesive tape was applied to the imaged surface and the image was transferred to the tape, according to the procedures of Examples 59—94.

Table VI illustrates the quality of the transfer achieved with various bond paper copiers and release surfaces.

TABLE VI

Quality of Transfer vs. Copier Type and Release Surface

| Example No. | Copier: IBM Copier II | Eastman Ektaprint (TM) | 3M Secretary II | 3M Secretary III | 3M DDS Platemaker (TM) | Release Surface | Quality of Transfer |
|---|---|---|---|---|---|---|---|
| 95 | X | | | | | a | clean[e] |
| 96 | | X | | | | a | clean |
| 97 | | | X | | | a | clean |
| 98 | | | | X | | a | clean |
| 99 | | | | | X | a | clean |
| 100 | | | | | X | b | clean |
| 101 | | | | | X | c | clean |
| 102 | | | | | X | d | clean |

Footnotes

a) 300 parts of 20 percent polyesterurethane in tetrahydrofuran, 30 parts of tris(2-acryloxyethyl)-isocyanurate

b) 0.3 percent

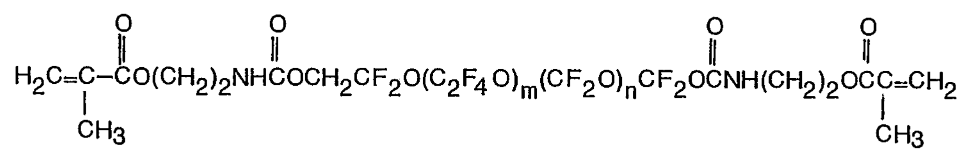

wherein m/n has an average value of about 0.5, and wherein the compound has a number average molecular weight of about 4690; 66.5 percent polyesturethane; and 33.2 percent tris(2-acryloxyethyl)-isocyanurate.

TABLE VI (Continued)

Footnotes (continued)

c) 0.15 percent

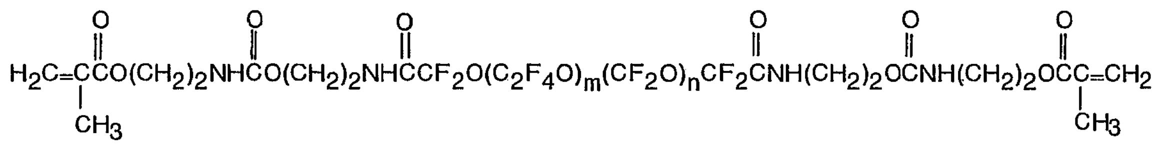

wherein m/n has an average value of about 0.6 and wherein the compound has a number average molecular weight of about 2310; 66.57 percent polyesterurethane; and 33.28 percent tris(2-acryloxyethyl)-isocyanurate.

d) 0.6 percent

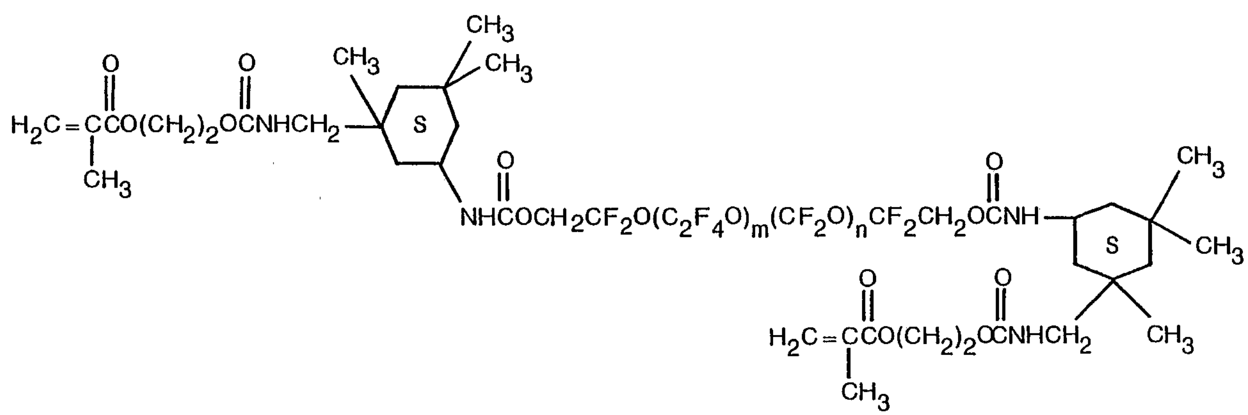

wherein m/n has an average value of about 0.5 and the number average molecular weight of the compound is about 5450; 66.3 percent polyesterurethane; and 33.1 percent tris(2-acryloxyethyl)-isocyanurate.

e) 100% of fused xerographic image was transferred to the tape.

**Claims**

1. A radiation curable composition for providing solvent-resistant abhesive coatings comprising:
a fluorocarbon;
a polyethylenically unsaturated crosslinking agent which differs from said fluorocarbon; and
a film-forming organic polymer;
characterized in that said fluorocarbon is a polyfluorinated acrylate compound present in an amount such that said composition is provided with at least 0.05 percent by weight fluorine.

2. The composition of Claim 1 further characterized by the feature that said polyfluorinated acrylate compound is a polyfluorinated acrylate or methacrylate having the general formula

$$R_f—X—A$$

wherein:
*$R_f$* is a polyfluorinated, saturated monovalent, aliphatic radical that is straight, branched or cyclic;
*A* is an ethylenically unsaturated group selected from the group consisting of

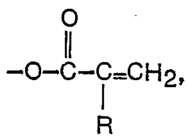, 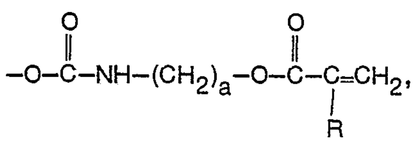, and 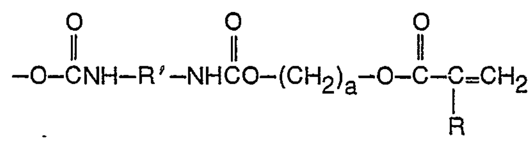

wherein:
R is selected from the group consisting of hydrogen and methyl, a is an integer having a value of 2 to 6, and R′ is selected from the group consisting of a divalent aliphatic group having 2 to 14 carbon atoms, a divalent cycloaliphatic group having 2 to 14 carbon atoms, and an aryl group having 6 to 14 carbon atoms; and
*X* is a connecting group selected from the group consisting of

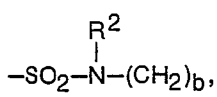, $-(CH_2)_{b'}$, and 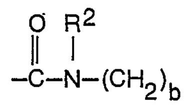

wherein:
b is 2 to 12, B′ is 1 to 12, and $R^2$ is selected from the group consisting of hydrogen, an alkyl group of 1 to 4 carbon atoms and $-(CH_2)_c-A$,
wherein:
A is defined as said A hereinabove, c is 2 or 3, and wherein when $R^2$ is $-(CH_2)_c-A$, b is 2 or 3; and
wherein when $R_f$ contains 6, 7 or more than 7 carbon atoms there are 6 or fewer, 10 or fewer, or 20 or fewer atoms respectively in the chain between $R_f$ and A.

3. The composition of Claim 1 further characterized by the feature that said polyfluorinated acrylate compound is a poly(fluorooxyalkylene)acrylate or methacrylate having the general formula

$$Z—R_f^2—Y—A$$

wherein
$R_f^2$ is a divalent poly(fluorooxyalkylene) group having a number average molecular weight of from about 500 to 20,000;
A is an ethylenically unsaturated group selected from the group consisting of

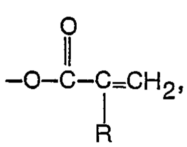, 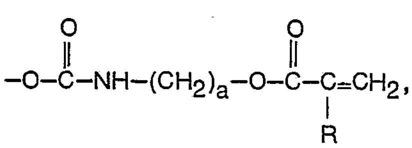, and 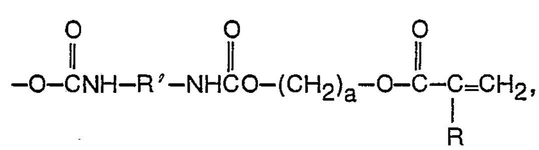,

wherein:
R is selected from the group consisting of hydrogen and methyl, a is an integer having a value of 2 to 6, and R′ is selected from the group consisting of a divalent aliphatic or cycloaliphatic group having 2 to 14 carbon atoms and an aryl group having 6 to 14 carbon atoms;

Y is selected from the group consisting of

$-CH_2-$ and 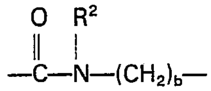

wherein:

b is 2 to 12, $R^2$ is selected from the group consisting of hydrogen, an alkyl group of 1 to 4 carbon atoms, and $-(CH_2)_c-A$, wherein A is defined as said A hereinabove, c is 2 or 3, and wherein, when $R^2$ is $-(CH_2)_c-A$, b is 2 or 3; and

Z is selected from the group consisting of $CF_3O-$, $CF_3OCF(CF_3)O-$, and —Y—A, wherein Y and A are defined as said Y and A hereinabove.

4. The composition of Claim 1 further characterized by the feature that said composition further comprises additives selected from the group consisting of coating aids, wetting agents, flatting agents, dyes, ultraviolet absorbers, pigments, particulate materials, monoethylenically unsaturated modifying compounds, a source of free radicals, sensitizers, and mixtures thereof.

5. An article comprising a substrate having a radiation curable composition carried thereon characterized in that said radiation curable coating composition is the composition of claim 1.

6. An article according to Claim 5 further characterized by the feature that said coating composition has been radiation cured.

7. A poly(fluorooxyalkylene)urethane acrylate or methacrylate characterized in that said acrylate or methacrylate has the general formula:

$$Z-R_f^2-Y-A'$$

wherein:

$R_f^2$ is a divalent poly(fluorooxyalkylene) group having a number average molecular weight of from about 500 to 20,000;

A' is selected from the group consisting of

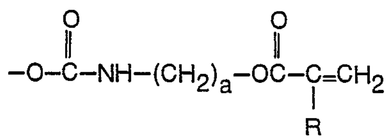 and 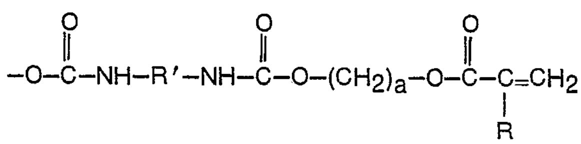

wherein:

R is selected from the group consisting of hydrogen and methyl, a is an integer having a value of 2 to 6, and R' is selected from the group consisting of a divalent aliphatic or cycloaliphatic group having 2 to 14 carbon atoms and an aryl group having 6 to 14 carbon atoms;

Y is selected from the group consisting of

$-CH_2-$ and 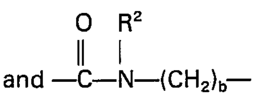

wherein:

b is 2 to 12, $R^2$ is selected from the group consisting of hydrogen, an alkyl group of 1 to 4 carbon atoms, and $(CH_2)_c-A'$, wherein c is 2 or 3, and wherein when $R^2$ is $-(CH_2)_c-A'$, b is 2 or 3; and

Z is selected from the group consisting of $CF_3O-$, $CF_3OCF(CF_3)O-$, —Y—A', and wherein Y and A' are defined as said Y and said A' hereinabove.

8. An image transfer process for transferring an image from a release surface to a receiver surface of the type comprising the steps of

(a) applying an image to a release coated surface of a first support base;

(b) adhering an adhesive surface of an adhesive coated second support base over said image on said release coated surface of said first support base;

(c) applying sufficient pressure to said second support base to effect intimate contact between said adhesive surface of said second support base and said image on said release coated surface of said first support base;

(d) separating said image bearing first support base from said second support base, with said image being transferred to said adhesive layer of said second support base;

characterized in that said release coating on said first support base comprises a layer of the coating composition of claim 1 which has been radiation cured; and further characterized by the feature that said process comprises a further step

(e) securing said adhesive layer of said second support base, now bearing said image, onto a different receiver surface by the application of pressure to provide said receiver surface with a protected image.

9. The process of Claim 8 further characterized by the feature that said image is applied to said release coated surface of said first support base by means selected from the group consisting of xerography, printing, silk screening, stenciling, electrography, electrophotography and the like.

**Revendications**

1. Une composition durcissable par irradiation pour fournir des revêtements adhésifs résistant aux solvants comprenant:

un fluorocarbure,

un agent réticulant à insaturation polyéthylénique qui diffère dudit fluorocarbure, et

un polymère organique filmogène;

caractérisée en ce que ledit fluorocarbure est un composé de type acrylate polyfluoré présent en une quantité telle que ladite composition contienne au moins 0,05% en pòids de fluor.

2. La composition de la revendication 1, caractérisée de plus par le fait que ledit composé de type acrylate polyfluoré est un acrylate ou méthacrylate polyfluoré répondant à la formule générale

$$R_f—X—A$$

dans laquelle:

$R_f$ est un radical aliphatique monovalent saturé polyfluoré qui est droit, ramifié ou cyclique.

A est un groupe à insaturation éthylénique choisi dans le groupe consisté par

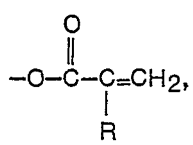 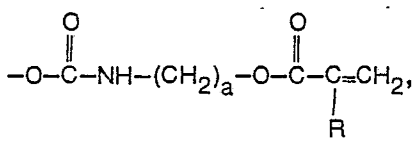 et 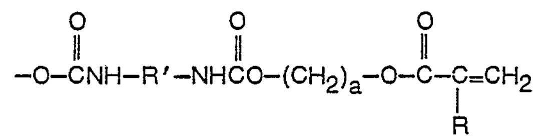

où:

R est choisi dans le groupe constitué par un hydrogène et un méthyle, a est un entier ayant une valeur de 2 à 6, et R' est choisi dans le groupe constitué par un groupe aliphatique divalent ayant 2 à 14 atomes de carbone, un groupe cycloaliphatique divalent ayant 2 à 14 atomes de carbone et un groupe aryle ayant 6 à 14 atomes de carbone; et

X est un groupe de raccordement choisi parmi de groupe constitué·par

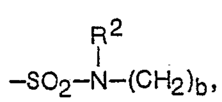 $-(CH_2)_{b'}$, et 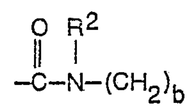

ou:

b est 2 à 12, b' est 1 à 12 et $R^2$ est choisi dans le groupe constitué par un hydrogène, un groupe alkyle de 1 à 4 atomes de carbone et $-(CH_2)_c-A$,

ou:

A est défini comme ledit A précédent, c est 2 ou 3, et où, lorsque $R^2$ est $-(CH_2)_c-A$, b est 2 ou 3; et où lorsque $R_f$ contient 6, 7 ou plus de 7 atomes de carbone, il y a respectivement 6 ou moins, 10 ou moins, ou 20 ou moins atomes dans la chaîne entre $R_f$ et A.

3. La composition de la revendication 1, caractérisée de plus par le fait que ledit composé de type acrylate polyfluoré est un poly(fluorooxyalkylène)acrylate ou -méthacrylate répondant à la formule générale

$$Z—R_f^2—Y—A$$

où:

$R_f^2$ est un groupe poly(fluoro-oxyalkylène) divalent ayant une moyenne numérique du poids moléculaire d'environ 500 à 20.000;

A est un groupe à insaturation éthylénique choisi dans le groupe constitué par

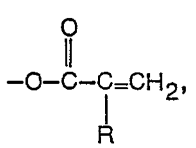 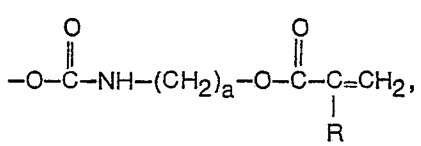 et 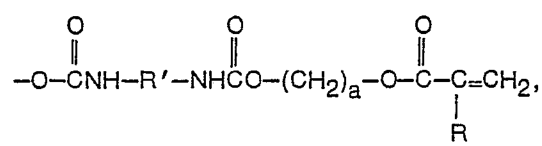

où:

R est choisi dans le groupe constitué par un hydrogène et un méthyle, a est un entier ayant une valeur de 2 à 6, et R′ est choisi dans le groupe consitué par un groupe aliphatique ou cycloaliphatique divalent ayant 2 à 14 atomes de carbone et un groupe aryle ayant 6 à 14 atomes de carbone;

Y est choisi dans le groupe constitué par

$$-CH_2- \text{ et } -\overset{O}{\overset{\|}{C}}-\overset{R^2}{\overset{|}{N}}-(CH_2)_b-$$

où:

b est 2 à 12, $R^2$ est choisi dans le groupe constitué par un hydrogène, un groupe alkyle de 1 à 4 atomes de carbone et $-(CH_2)_c-A$, où A est défini comme ledit A ci-dessus, c est 2 ou 3, et où, lorsque $R^2$ est $-(CH_2)_c-A$, b est 2 ou 3; et

Z est choisi dans le groupe constitué par $CF_3O-$, $CF_3OCF(CF_3)O-$, et Y—A, où Y et A sont définis comme lesdits Y et A ci-dessus.

4. La composition de la revendication 1, caractérisée de plus par le fait que ladite composition comprend de plus des additifs choisis dans le groupe constitué par les aides de revêtement, les agents mouillants, les agents matants, les colorants, les absorbants des ultraviolets, les pigments, les matières particulaires, les composés modificateurs à insaturation monoéthylénique, une source de radicaux libres, les sensibilisateurs et leurs mélanges.

5. Un article comprenant un substrat portant une composition de revêtement durcissable par irradiation, caractérisé en ce que ladite composition de revêtement durcissable par irradiation est la composition de la revendication 1.

6. Un article selon la revendication 5, caractérisé de plus par le fait que ladite composition de revêtement a été durcie par irradiation.

7. Un poly(fluoro-oxyalkylène)uréthane acrylate ou méthacrylate, caractérisé en ce que ledit acrylate ou méthacrylate répond à la formule générale:

$$Z-R_f^2-Y-A'$$

ou:

$R_f^2$ est un groupe poly(fluoro-oxyalkylène) divalent ayant une moyenne numérique du poids moléculaire d'environ 500 à 20.000,

A′ est choisi dans le groupe constitué par

$$-O-\overset{O}{\overset{\|}{C}}-NH-(CH_2)_a-O\overset{O}{\overset{\|}{C}}-\underset{R}{\underset{|}{C}}=CH_2 \quad \text{et} \quad -O-\overset{O}{\overset{\|}{C}}-NH-R'-NH-\overset{O}{\overset{\|}{C}}-O-(CH_2)_a-O-\overset{O}{\overset{\|}{C}}-\underset{R}{\underset{|}{C}}=CH_2$$

où:

R est choisi dans le groupe constitué par un hydrogène et un méthyle, a est un entier ayant une valeur de 2 à 6, et R′ est choisi dans le groupe constitué par un groupe aliphatique ou cycloaliphatique divalent ayant 2 à 14 atomes de carbone et un groupe aryle ayant 6 à 14 atomes de carbone;

Y est choisi dans le groupe constitué par

$$-CH_2- \text{ et } -\overset{O}{\overset{\|}{C}}-\overset{R^2}{\overset{|}{N}}-(CH_2)_b-$$

où:

b est 2 à 12, $R^2$ est choisi dans le groupe constitué par un hydrogène, un groupe alkyle de 1 à 4 atomes de carbone, et $-(CH_2)_c-A'$, où c est 2 ou 3, et où lorsque $R^2$ est $-(CH_2)_c-A'$, b est 2 ou 3; et

Z est choisi dans le groupe constitué par $CF_3O-$, $CF_3OCF(CF_3)O-$, —Y—A′, et où Y et A′ sont définis comme ledit Y et ledit A′ ci-dessus.

8. Un procédé de transfert d'image pour transférer une image d'une surface de séparation à une surface réceptrice du type comprenant les stades de:

(a) application d'un image à une surface de revêtement de séparation d'un première base support;

(b) adhérence d'une surface adhésive d'une seconde base support à revêtement adhésif sur ladite image sur la surface à revêtement de séparation de ladite première base support;

(c) application d'une pression suffisante à ladite seconde base support pour effectuer un contact intime entre ladite surface adhésive de ladite seconde base support et ladite image sur ladite surface à revêtement de séparation de ladite première base support;

(d) séparation de ladite première base support portant l'image de ladite seconde base support, avec transfert de ladite image à ladite couche adhésive de ladite seconde base support; caractérisé en ce que ledit revêtement de séparation sur ladite première base support comprend une couche de la composition de revêtement de la revendication 1 qui a été durcie par irradiation; et caractérisé de plus par le fait que ledit procédé comprend de plus un stade de

(e) assujettissement de ladite couche adhésive de ladite seconde base support, portant alors ladite image, sur une surface réceptrice différente par application de pression pour munir ladite surface réceptrice d'une image protégée.

9. Le procédé de la revendication 8, caractérisé de plus par le fait que ladite image est appliquée à ladite surface à revêtement de séparation de ladite première base support selon un moyen choisi dans le groupe constitué par la xérographie, l'impression, la sérigraphie, la reproduction par stencil, l'électrographie, l'électrophotographie et similaires.

**Patentansprüche**

1. Strahlungshärtbare Zusammensetzung zum Erzeugen von lösungsmittelbeständigen Klebstoffüberzügen, enthaltend:

Einen Fluorkohlenstoff;

ein polyethylenisch ungesättigtes Vernetzungsmittel, das sich von dem Fluorkohlenstoff unterscheidet; und ein filmbilden- des organisches Polymerisat;

dadurch gekennzeichnet, daß der Fluorkohlenstoff eine polyfluorierte Acrylatverbindung ist, die in einer solchen Menge vorhanden ist, daß die Zusammensetzung mindestens 0,05 Gew.% Fluor enthält.

2. Zusammensetzung nach Anspruch 1, dadurch gekennzeichnet, daß die polyfluorierte Acrylatverbindung ein polyfluoriertes Acrylat oder Methacrylat mit der allgemeinen Formel

$$R_f—X—A$$

ist, in der

$R_f$ ein polyfluoriertes gesättigtes einwertiges, aliphatisches Radikal ist, das geradkettig, verzweigt oder zyklish ist,

A eine ethylenisch gesättigte Gruppe ist, die ausgewählt ist aus

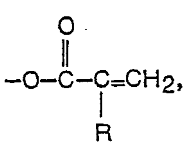, 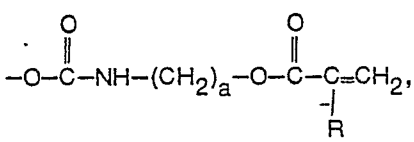, und 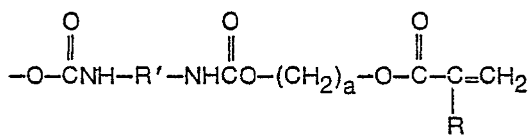

wobei R aus Wasserstoff und Methyl ausgewählt ist, a eine ganze Zahl mit einem Wert von 2 bis 6 ist und R' ausgewählt ist aus den zweiwertigen aliphatischen Gruppen mit 2 bis 14 Kohlenstoffatomen, den zweiwertigen cycloaliphatischen Gruppen mit 2 bis 14 Kohlenstoffatomen und den Arylgruppen mit 6 bis 14 Kohlenstoffatomen; und X eine Verbindungsgruppe ist, die ausgewählt ist aus

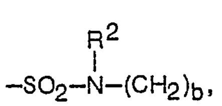, $-(CH_2)_{b'}$, und 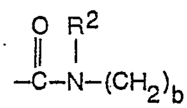

wobei b 2 bis 12 und b' 1 bis 12 ist und $R^2$ ausgewählt ist aus Wasserstoff, den Alkylgruppen mit 1 bis 4 Kohlenstoffatomen und $-(CH_2)_c-A$, wobei A die vorstehend für A angegebene Bedeutung hat, c den Wert 2 oder 3 hat und wenn $R^2$ die Bedeutung $-(CH_2)_c-A$ hat, b den Wert 2 oder 3 hat, wobei wenn $R_f$ 6 oder 7 oder mehr als 7 Kohlenstoffatome enthält, die Kette zwischen $R_f$ und A 6 oder weniger bzw. 10 oder weniger bzw. 20 oder weniger Atome enthält.

3. Zusammensetzung nach Anspruch 1, dadurch gekennzeichnet, daß die polyfluorierte Acrylatverbindung ein Poly(fluoroxyalkylen)acralat oder -methacrylat der allgemeinen Formel

$$Z—R_f^2—Y—A$$

ist, in der

$R_f^2$ eine zweiwertige Poly(fluoroxyalkylen)gruppe mit einem zahlenmäßig durchschnittlichen Molekulargewicht von etwa 500 bis 20,000 ist,

A eine ethylenisch ungesättigte Gruppe ist, die ausgewählt ist aus

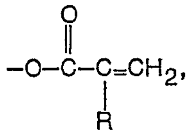, 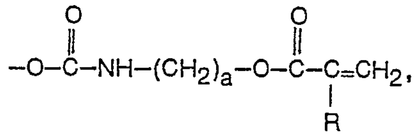, und 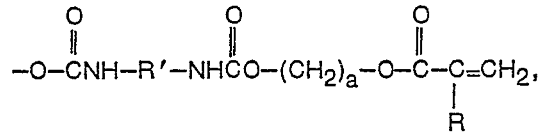,

wobei R aus Wasserstoff und Methyl ausgewählt ist, a eine ganze Zahl mit einem Wert von 2 bis 6 ist und R' ausgewählt ist aus den zweiwertigen aliphatischen Gruppen mit 2 bis 14 Kohlenstoffatomen, den zweiwertigen cycloaliphatischen Gruppen mit 2 bis 14 Kohlenstoffatomen und den Arylgruppen mit 6 bis 14 Kohlenstoffatomen; Y ausgewählt ist aus

$—CH_2—$ und 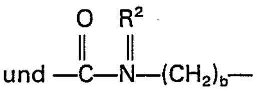

in der b 2 bis 12 ist, $R^2$ ausgewählt ist aus Wasserstoff, den Alkylgruppen mit 1 bis 4 Kohlenstoffatomen und $-(CH_2)_c-A$, wobei A die vorstehend für A angegebene Bedeutung hat, c den Wert 2 oder 3 hat und wenn $R^2$ die Bedeutung $-(CH_2)_c-A$ hat, b den Wert 2 oder 3 hat,

Z ausgewählt ist aus $CF_3O—$, $CF_3OCF(CF_3)O—$ und —Y—A, wobei Y und A die vorstehend für A bzw. Y angegebenen Bedeutungen haben.

4. Zusammensetzung nach Anspruch 1, dadurch gekennzeichnet, daß die Zusammensetzung ferner Zusatzstoffe enthält, die ausgewählt sind aus den Beschichtungshilfsstoffen, Netzmitteln, Verlaufmitteln Farbstoffen, UV-Absorbern, Pigmenten, feinteiligen Stoffen, monoethylenisch ungesättigten Modifizierungsverbindungen, Quellen von freien Radikalen, Sensibilisatoren und Gemischen derselben.

5. Gegenstand mit einem Substrat, auf dem eine strahlungshärtbare Überzugszusammensetzung vorgesehen ist, dadurch gekennzeichnet, daß die strahlungshärtbare Überzugszusammensetzung die Zusammensetzung nach Anspruch 1 ist.

6. Gegenstand nach Anspruch 5, dadurch gekennzeichnet, daß die Überzugszusammensetzung strahlungsgehärtet ist.

7. Poly(fluoroxyalkylen)urethanacrylat oder -methacrylat, dadurch gekennzeichnet, daß das Acrylat oder Methacrylat die allgemeine Formel

$$Z—R_f^2—Y—A'$$

hat, in der

$R_f^2$ eine zweiwertige Poly(fluoroxyalkylen)gruppe mit einem zahlenmäßig durchschnittlichen Molekulargewicht von etwa 500 bis 20,000 ist,

A' ausgewählt ist aus

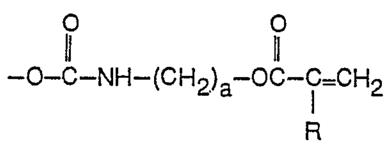 und 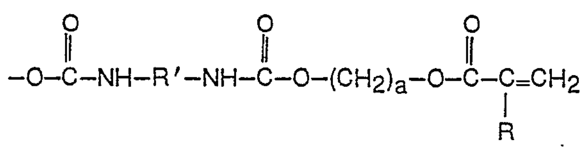

wobei R aus Wasserstoff und Methyl ausgewählt ist, a eine ganze Zahl mit einem Wert von 2 bis 6 ist und R' ausgewählt ist aus den zweiwertigen aliphatischen Gruppen mit 2 bis 14 Kohlenstoffatomen, den zweiwertigen cycloaliphatischen Gruppen mit 2 bis 14 Kohlenstoffatomen und den Arylgruppen mit 6 bis 14 Kohlenstoffatomen;

Y ausgewählt ist aus

$—CH_2—$ und 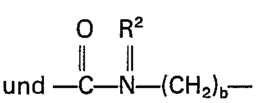

in der b 2 bis 12 ist, $R^2$ ausgewählt ist aus Wasserstoff, den Alkylgruppen mit 1 bis 4 Kohlenstoffatomen und $-(CH_2)_c-A$, wobei A die vorstehend für A angegebene Bedeutung hat, c den Wert 2 oder 3 hat und wenn $R^2$ die Bedeutung $-(CH_2)_c-A$ hat, b den Wert 2 oder 3 hat, und $-(CH_2)_c-A'$, wobei c 2 oder 3 ist und, wenn $R^2$ die Bedeutung $-(CH_2)_c-A'$ hat, b 2 oder 3 ist und wobei Z ausgewählt ist aus $CF_3O—$, $CF_3OCF(CF_3)O—$ und —Y—A' und Y und A' die vorstehend für Y bzw. A' angegebene Bedeutungen haben.

8. Bildübertragungsverfahren zum Übertragen eines Bildes von einer Abgabefläche auf eine Aufnahmefläche, mit folgenden Schritten:

(a) Ein Bild wird auf eine mit einem Antihaftüberzug versehene Fläche eines ersten Substrats aufgetragen;

(b) eine Klebfläche eines klebstoffüberzogenen zweiten Substrats wird mit dem Bild auf der mit dem Antihaftmittel überzogenen Fläche des ersten Substrats verklebt;

(c) auf das zweite Substrat wird ein so starker Druck ausgeübt, daß zwischen der Klebfläche des zweiten Substrats und dem auf der mit dem Antihaftmittel überzogenen Fläche des ersten Substrats vorhandenen Bild eine satte Berührung hergestellt wird; und

(d) das bildtragende erste Substrat wird von dem zweiten Substrat getrennt, wobei das Bild auf die Klebstoffschicht des zweiten Substrats übertragen wird,

dadurch gekennzeichnet, daß der Antihaftüberzug auf dem ersten Substrat wenigstens teilweise aus einer strahlungsgehärteten Schicht der Überzugszusammensetzung nach Anspruch 1 besteht, und daß das Verfahren zusätzlich folgenden Schritt umfaßt:

(e) Die jetzt das Bild tragende Klebstoffschicht des zweiten Substrats wird durch Druckausübung an einer anderen Aufnahmefläche befestigt, die dadurch mit einem geschützten Bild versehen wird.

9. Verfahren nach Anspruch 8, dadurch gekennzeichnet, daß das Bild auf mit dem Antihaftmittel überzogene Fläche des ersten Substrats durch Xerographie, Drucken, Siebdrucken, Schablonieren, Elektrographie, Elektrophotographie und dergleichen aufgetragen wird.

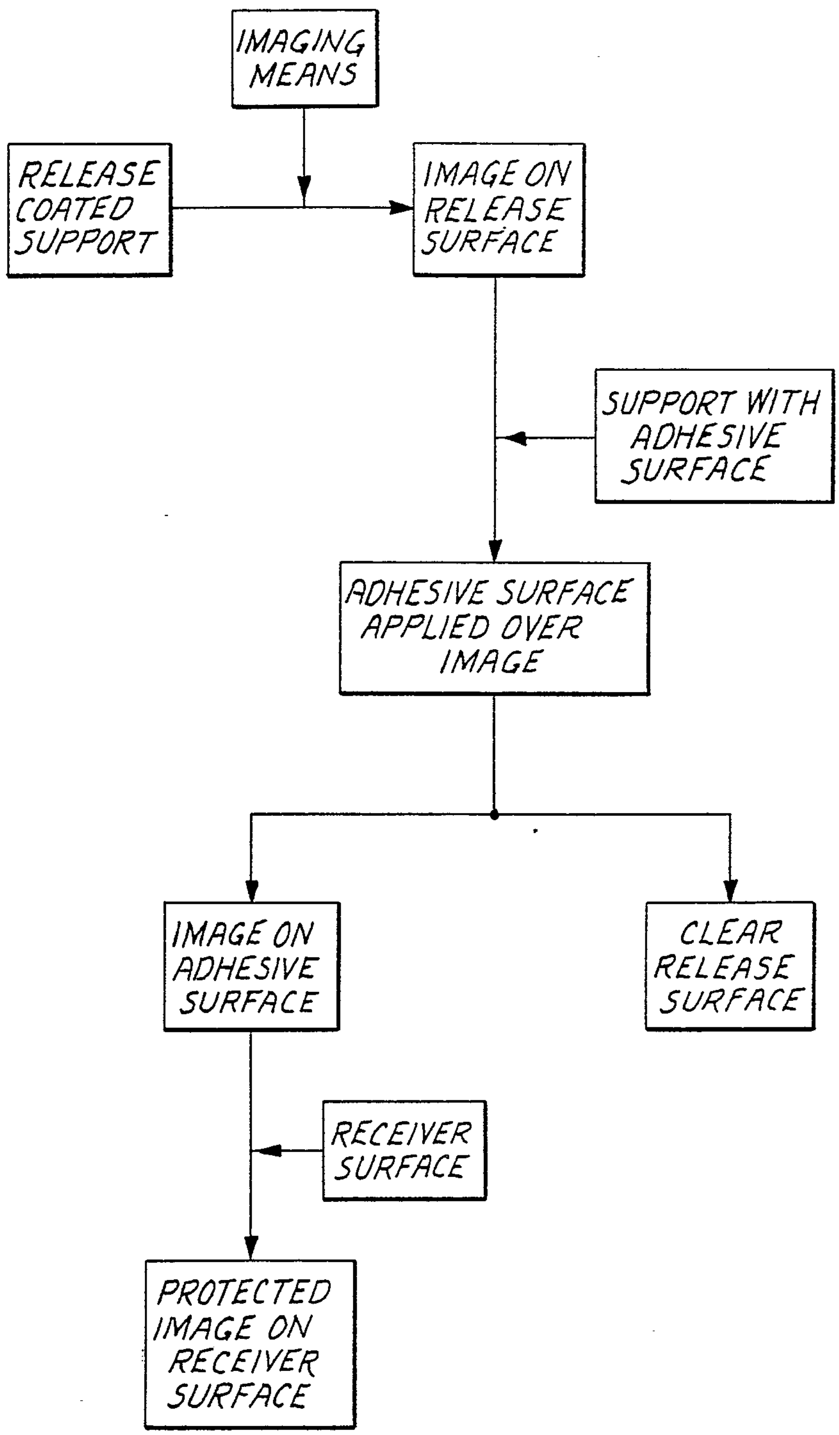
IMAGING MEANS
RELEASE COATED SUPPORT
IMAGE ON RELEASE SURFACE
SUPPORT WITH ADHESIVE SURFACE
ADHESIVE SURFACE APPLIED OVER IMAGE
IMAGE ON ADHESIVE SURFACE
CLEAR RELEASE SURFACE
RECEIVER SURFACE
PROTECTED IMAGE ON RECEIVER SURFACE